(19) **Europäisches Patentamt / European Patent Office / Office européen des brevets**

(11) **EP 4 586 567 A1**

(12) **EUROPEAN PATENT APPLICATION**
published in accordance with Art. 153(4) EPC

(43) Date of publication:
**16.07.2025 Bulletin 2025/29**

(21) Application number: **22960414.5**

(22) Date of filing: **30.09.2022**

(51) International Patent Classification (IPC):
***H04L 27/00*** *(2006.01)*

(52) Cooperative Patent Classification (CPC):
**H04L 27/00**

(86) International application number:
**PCT/CN2022/123576**

(87) International publication number:
**WO 2024/065804 (04.04.2024 Gazette 2024/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventors:
• **XIE, Junwen
Shenzhen, Guangdong 518129 (CN)**
• **MA, Mengyao
Shenzhen, Guangdong 518129 (CN)**
• **DU, Yuqing
Shenzhen, Guangdong 518129 (CN)**
• **YAN, Min
Shenzhen, Guangdong 518129 (CN)**

(74) Representative: **Pfenning, Meinig & Partner mbB
Patent- und Rechtsanwälte
Theresienhöhe 11a
80339 München (DE)**

(54) **DATA COMPRESSION AND TRANSMISSION METHOD AND APPARATUS, DEVICE, AND STORAGE MEDIUM**

(57) This application provides a data compression and transmission method, an apparatus, a device, and a storage medium. The method includes: A first communication apparatus performs weighted encoding on first data based on a dictionary matrix, to obtain second data, where the second data expresses the first data based on k basis vectors in the dictionary matrix; and sends the second data to a second communication apparatus on a first transmission resource, to compress physical layer data while a low data loss is ensured. Further, k is a weighting parameter that is determined based on the first transmission resource and that is of the first data, and the weighting parameter k used for performing weighted encoding on the first data is determined based on the first transmission resource, thereby achieving a balance between a transmission resource and compression performance.

FIG. 4

**Description**

**TECHNICAL FIELD**

This application relates to the field of communication technologies, and in particular, to a data compression and transmission method, an apparatus, a device, and a storage medium.

**BACKGROUND**

Technologies such as artificial intelligence (artificial intelligence, AI), autonomous driving, and scenario reconstruction are becoming increasingly mature. In a communication system, a data amount of data, for example, AI model parameter data, perception data, and point cloud data, generated at a physical layer in these scenarios is excessively large. Consequently, a large quantity of transmission resources are occupied when the data is transmitted between communication devices, and a transmission delay is increased. In view of this, before data transmission, data compression may be performed on to-be-transmitted data in a scalar quantization manner or a vector quantization manner, and then compressed data is transmitted, to save transmission resources and reduce a transmission delay. However, for data compression performed on the to-be-transmitted data through scalar quantization or vector quantization, a compression rate is low, and the compressed data is subject to a large data loss. Therefore, how to implement effective and reliable data compression and transmission is an urgent problem to be resolved currently.

**SUMMARY**

Embodiments of this application provide a data compression and transmission method, an apparatus, a device, and a storage medium, to implement effective and reliable data compression and transmission.

According to a first aspect, this application provides a data compression and transmission method, including: A first communication apparatus performs weighted encoding on first data based on a dictionary matrix, to obtain second data. The second data expresses the first data based on k basis vectors in the dictionary matrix, k is a weighting parameter that is determined based on a first transmission resource and that is of the first data, and k is an integer greater than or equal to 1. The first communication apparatus sends the second data to a second communication apparatus on the first transmission resource.

According to the data compression and transmission method provided in the first aspect, weighted encoding is performed on the to-be-transmitted first data, to express the to-be-transmitted first data based on the k basis vectors, so that physical layer data is compressed while a low data loss is ensured. Further, the weighting parameter k used to perform weighted encoding on the first data is determined based on the first transmission resource, so that a balance between the transmission resource and compression performance is implemented, to avoid a case in which when transmission resources are sufficient, a large amount of transmitted data is lost due to excessive compression, or a case in which when transmission resources are insufficient, the compressed data cannot be transmitted due to a large amount of compressed data. Effective and reliable data compression is performed on the to-be-transmitted data.

In a possible implementation, the first data includes M first datasets, the M first datasets are clustered into N second datasets, the second dataset includes at least one first dataset, and M and N are both integers greater than or equal to 1.

According to the data compression and transmission method provided in this implementation, the first data is clustered, and dictionary learning and a sparse representation are performed on clustered data for transmission. When a data amount of the to-be-transmitted first data is large, overheads of the dictionary matrix are reduced, and a sparse representation with better sparsity is learned.

In a possible implementation, the weighting parameter k of the first data includes a first weighting parameter $k_i'$ corresponding to an $i^{th}$ second dataset in the N second datasets. The second data includes an $i^{th}$ first sub-dataset obtained by performing weighted encoding on the $i^{th}$ second dataset based on the first weighting parameter $k_i'$, and the $i^{th}$ first sub-dataset expresses the $i^{th}$ second dataset based on $k_i'$ basis vectors in the dictionary matrix.

According to the data compression and transmission method provided in this implementation, when weighted encoding is performed on each second dataset, the expression of the first sub-dataset for the second dataset may be sparser based on the first weighting parameter k' corresponding to the second dataset. In other words, the first data is efficiently compressed based on the second data.

In a possible implementation, the first weighting parameter $k_i'$ is determined based on a data feature of the $i^{th}$ second dataset.

According to the data compression and transmission method provided in this implementation, the data feature of the second dataset can reflect a data amount proportion of the second dataset in the first data. When the $i^{th}$ second dataset occupies a large amount of data in the first data, weighted encoding is performed on the $i^{th}$ second dataset based on a large

first weighting parameter $k_i'$, so that the $i^{th}$ first sub-dataset expresses the $i^{th}$ second dataset based on a large quantity of basis vectors. When the $i^{th}$ second dataset occupies a small amount of data in the first data, weighted encoding is performed on the $i^{th}$ second dataset based on a small first weighting parameter $k_i'$, so that the $i^{th}$ first sub-dataset expresses the $i^{th}$ second dataset based on a small quantity of basis vectors. Sparse expression of second datasets of different data amounts is flexibly controlled, to implement the balance between the compression performance and the transmission resource.

In a possible implementation, the dictionary matrix includes N dictionary submatrices respectively corresponding to the N second datasets, and the N dictionary submatrices include at least two different dictionary submatrices.

According to the data compression and transmission method provided in this implementation, different second datasets are flexibly expressed.

In a possible implementation, the first weighting parameter $k_i'$ corresponding to the $i^{th}$ second dataset includes a second weighting parameter $k_i''$ corresponding to each first dataset in the $i^{th}$ second dataset. The $i^{th}$ first sub-dataset includes a $j^{th}$ piece of subdata obtained by performing weighted encoding on a $j^{th}$ first dataset in the $i^{th}$ second dataset based on the second weighting parameter $k_{ij}''$, and the $j^{th}$ piece of subdata in the $i^{th}$ first sub-dataset expresses the $j^{th}$ first dataset in the $i^{th}$ second dataset based on $k_{ij}''$ basis vectors in an $i^{th}$ dictionary submatrix corresponding to the $i^{th}$ second dataset.

According to the data compression and transmission method provided in this implementation, each piece of first data in each second dataset may correspond to one second weighting parameter, so that weighted encoding is performed on the first data at a finer granularity, thereby further improving the compression performance.

In a possible implementation, the second weighting parameter $k_{ij}''$ corresponding to the $j^{th}$ first dataset in the $i^{th}$ second dataset is determined based on a data feature of the $j^{th}$ first dataset in the $i^{th}$ second dataset.

According to the data compression and transmission method provided in this implementation, a data feature of the first dataset can reflect a data amount proportion of the $j^{th}$ first dataset in the $i^{th}$ second dataset. When the $j^{th}$ first dataset occupies a large amount of data in the $i^{th}$ second dataset, weighted encoding is performed on the $j^{th}$ first dataset based on a large second weighting parameter $k_{ij}''$, so that the $j^{th}$ piece of subdata in the $i^{th}$ first sub-dataset expresses the $j^{th}$ first dataset based on a large quantity of basis vectors. When an $i^{th}$ first dataset occupies a small amount of data in the $i^{th}$ second dataset, weighted encoding is performed on the $j^{th}$ first dataset based on a small second weighting parameter $k_{ij}''$, so that the $j^{th}$ piece of subdata in the $i^{th}$ first sub-dataset expresses the $j^{th}$ first dataset based on a small quantity of basis vectors. Sparse expression of first datasets of different data amounts is flexibly controlled, to implement the balance between the compression performance and the transmission resource.

In a possible implementation, K basis vectors in third data include $K_i'$ basis vectors corresponding to the $i^{th}$ second dataset, the third data is obtained by performing weighted encoding on each second dataset in the first data, the K basis vectors include the k basis vectors, and the $k_i'$ basis vectors in the $i^{th}$ second dataset are first $k_i'$ basis vectors that are in the $K_i'$ basis vectors and that are in descending order of capabilities of expressing the first data.

According to the data compression and transmission method provided in this implementation, the $i^{th}$ second dataset may be accurately expressed based on the $k_i'$ basis vectors.

In a possible implementation, the method further includes: The first communication apparatus sends P pieces of incremental data of the second data to the second communication apparatus, where P is an integer greater than or equal to 1. A $q^{th}$ piece of incremental data in the P pieces of incremental data includes an $i^{th}$ piece of first subdata, and the $i^{th}$ piece of first subdata expresses the $i^{th}$ second dataset based on $h_{(q, i)}$ basis vectors in the $i^{th}$ dictionary submatrix in the dictionary matrix, where $h_{(q, i)}$ is an integer less than K and greater than or equal to 1. The $q^{th}$ piece of incremental data is subdata of the third data, and the $i^{th}$ piece of first subdata includes location indication information and weighting coefficients of the $h_{(q, i)}$ basis vectors in the third data. Alternatively, a $q^{th}$ piece of incremental data is subdata of fourth data. The $i^{th}$ piece of first subdata includes weighting coefficients of $k_i'$ basis vectors in the fourth data and/or a basis vector in at least one of first q-1 pieces of incremental data in the P pieces of incremental data, and location indication information and weighting coefficients of the $h_{(q, i)}$ basis vectors in the fourth data. The fourth data is determined based on the $i^{th}$ dictionary submatrix, the first data, and fourth data corresponding to a $(q-1)^{th}$ piece of incremental data. When q is equal to 1, the fourth data corresponding to the $(q-1)^{th}$ piece of incremental data is the second data. A sum of quantities $\sum_{i=1}^{N}\sum_{q=1}^{P}h_{(q,i)}$

and $\sum_{i=1}^{N}k_i'$ of basis vectors in the P pieces of incremental data is less than or equal to K.

According to the data compression and transmission method provided in this implementation, layered incremental transmission is performed on the data that expresses the $i^{th}$ second dataset. When transmission resources are limited, a capability of expressing the $i^{th}$ second dataset is improved through incremental transmission.

In a possible implementation, the method further includes: The first communication apparatus performs weighted encoding on the first data to obtain the dictionary matrix and third data. The third data expresses the first data based on K basis vectors in the dictionary matrix, the K basis vectors include the k basis vectors, and K is an integer greater than or equal to k.

According to the data compression and transmission method provided in this implementation, the K basis vectors are not constrained by a resource size of the first transmission resource, to accurately express the first data and obtain the reliable dictionary matrix.

In a possible implementation, the k basis vectors are first k basis vectors that are in the K basis vectors in the dictionary matrix and that are in descending order of capabilities of expressing the first data.

According to the data compression and transmission method provided in this implementation, the compressed data transmitted via the first transmission resource can accurately express the first data.

In a possible implementation, the method further includes: The first communication apparatus sends P pieces of incremental data of the second data to the second communication apparatus, where P is an integer greater than or equal to 1. A $q^{th}$ piece of incremental data in the P pieces of incremental data is subdata of the third data, and the $q^{th}$ piece of incremental data includes location indication information and weighting coefficients of $h_q$ basis vectors in the third data. Alternatively, a $q^{th}$ piece of incremental data in the P pieces of incremental data is subdata of fourth data. The $q^{th}$ piece of incremental data includes weighting coefficients of the k basis vectors in the fourth data and/or a weighting coefficient of a basis vector in at least one of first q-1 pieces of incremental data in the P pieces of incremental data, and location indication information and weighting coefficients of $h_q$ basis vectors in the fourth data. The fourth data is determined based on the dictionary matrix, the first data, and fourth data corresponding to a $(q-1)^{th}$ piece of incremental data. When q is equal to 1, the fourth data corresponding to the $(q-1)^{th}$ piece of incremental data is the second data. $h_q$ is an integer less than K and greater than or equal to 1, and a sum of a quantity $\sum_{q=1}^{P} h_q$ of basis vectors in the P pieces of incremental data and k is less than or equal to K.

According to the data compression and transmission method provided in this implementation, layered incremental transmission is performed on the data that expresses the first data. When transmission resources are limited, a capability of expressing the first data is improved through incremental transmission.

In a possible implementation, the $h_q$ basis vectors are first $h_q$ basis vectors that are other than the k basis vectors in the K basis vectors and $\sum_{r=1}^{q-1} h_r$ basis vectors in the first q-1 pieces of incremental data and that are in descending order of capabilities of expressing the first data, where $h_r$ is a quantity of basis vectors in one of the first q-1 pieces of incremental data.

According to the data compression and transmission method provided in this implementation, the compressed data that is prepared to express the first data can be preferentially transmitted.

In a possible implementation, the second data includes location indication information and/or the weighting coefficients of the k basis vectors.

According to the data compression and transmission method provided in this implementation, the first data is accurately expressed by the second data.

In a possible implementation, the method further includes: The first communication apparatus performs quantization and/or entropy encoding on the second data to obtain compressed data of the second data. That the first communication apparatus sends the second data to a second communication apparatus on the first transmission resource includes: The first communication apparatus sends the compressed data of the second data to the second communication apparatus on the first transmission resource.

According to the data compression and transmission method provided in this implementation, a compression ratio of the first data is further improved.

In a possible implementation, the method further includes: The first communication apparatus sends the dictionary matrix to the second communication apparatus.

According to the data compression and transmission method provided in this implementation, the first communication apparatus sends, to the second communication apparatus, the dictionary matrix used when the first communication apparatus performs weighted encoding on the first data, so that the second communication apparatus can restore the first data based on the obtained dictionary matrix, to improve accuracy of data restoration.

In a possible implementation, the first communication apparatus may perform quantization and/or entropy encoding on the dictionary matrix, and send, to the second communication apparatus, a quantized and/or entropy-encoded dictionary matrix.

In a possible implementation, a data feature of the first dataset or the second dataset includes at least one of a data amount, data boundary values, and a mean variance.

According to the data compression and transmission method provided in this implementation, the data feature can reflect a data proportion of the first dataset or the second dataset in the first data.

In a possible implementation, the method further includes: The first communication apparatus clusters the M first datasets based on one of the following, to obtain the N second datasets: data types of the M first datasets; and boundary values of elements in the M first datasets.

According to the data compression and transmission method provided in this implementation, boundary values of elements in the obtained second dataset are close, and sparse expression of the second dataset can be implemented based on the dictionary matrix.

In a possible implementation, the method further includes: The first communication apparatus sends category indication information to the second communication apparatus, where the category indication information indicates a clustering category of each of the M first datasets.

According to the data compression and transmission method provided in this implementation, the second communication apparatus restores the first data.

In a possible implementation, the first communication apparatus receives indication information that is sent by the second communication apparatus and that is of a second transmission resource, and the second transmission resource is used to transmit incremental data of the second data.

According to the data compression and transmission method provided in this implementation, the transmission resource for transmitting the incremental data is flexibly configured.

In a possible implementation, the method further includes: The first communication apparatus sends a transmission request to the second communication apparatus, where the transmission request is used to request to send the incremental data of the second data.

According to the data compression and transmission method provided in this implementation, the first communication apparatus determines whether to send the incremental data of the second data, so that the first communication apparatus completely transmits the compressed data of the first data, thereby improving accuracy of the restored first data.

In a possible implementation, the method further includes: The first communication apparatus receives compression indication information sent by the second communication apparatus. The compression indication information includes compression hyperparameter information, the compression hyperparameter information indicates at least a target weighting parameter, the target weighting parameter is used to determine k, and the target weighting parameter is greater than or equal to k.

According to the data compression and transmission method provided in this implementation, a maximum value of the weighting parameter is indicated, to prevent a transmission resource occupied by the second data transmitted by the first communication apparatus from exceeding the first transmission resource.

In a possible implementation, the method further includes: The first communication apparatus sends the compression indication information to the second communication apparatus. The compression indication information includes the compression hyperparameter information, the compression hyperparameter information indicates at least the target weighting parameter, the target weighting parameter is used to determine k, and the target weighting parameter is greater than or equal to k.

According to the data compression and transmission method provided in this implementation, the second communication apparatus determines, based on the target weighting parameter, the first transmission resource that can carry the second data.

In a possible implementation, the compression hyperparameter information includes at least one of the following: configuration information of the first transmission resource, where the first transmission resource indicates the target weighting parameter; and information indicating a dimension of a basis vector and/or a quantity of basis vectors in the dictionary matrix.

According to the data compression and transmission method provided in this implementation, the first transmission resource indicates the target weighting parameter, thereby reducing signaling overheads. The dimension of a basis vector and/or basis vector data of the dictionary matrix are/is indicated, thereby flexibly configuring the dictionary matrix.

In a possible implementation, the compression indication information further includes at least one of the following: information indicating a clustering manner of the M first datasets in the first data; information indicating a compression manner of one or more of the N second datasets in the first data; and information indicating whether to perform entropy encoding on the second data.

According to the data compression and transmission method provided in this implementation, a manner used in a compression and transmission process is flexibly configured.

In a possible implementation, the first communication apparatus determines the compression manner of the one or more of the N second datasets based on a data feature of the first data.

According to the data compression and transmission method provided in this implementation, the second data may be compressed and transmitted in a corresponding compression manner based on a data feature of the second data, thereby improving the compression performance.

In a possible implementation, the method further includes: The first communication apparatus sends compression parameter information to the second communication apparatus, where the compression parameter information includes at least one of the following: boundary values of the dictionary matrix; and boundary values of the weighting coefficients of the basis vectors in the second data.

According to the data compression and transmission method provided in this implementation, accuracy of restoring the first data by the second communication apparatus can be improved.

In a possible implementation, the method further includes: The first communication apparatus sends feedback information to the second communication apparatus, where the feedback information includes a weighting parameter $k_m$, and the weighting parameter $k_m$ is used to adjust a size of a transmission resource in a next round.

According to the data compression and transmission method provided in this implementation, the size of the transmission resource in the next round is dynamically adjusted based on the currently fed-back weighting parameter $k_m$, to flexibly control the transmission resource, so that the transmission resource can match the to-be-transmitted data. This avoids impact of a resource waste or insufficient resource configuration on transmission performance.

According to a second aspect, an embodiment of this application provides a data compression and transmission method, including: A second communication apparatus receives, on a first transmission resource, second data from a first communication apparatus. The second data expresses first data based on k basis vectors in a dictionary matrix, k is a weighting parameter that is determined based on the first transmission resource and that is of the first data, and k is an integer greater than or equal to 1. The second communication apparatus constructs the first data based on the second data and the dictionary matrix.

In a possible implementation, the first data includes M first datasets, the M first datasets are clustered into N second datasets, the second dataset includes at least one first dataset, and M and N are both integers greater than or equal to 1.

In a possible implementation, the weighting parameter k of the first data includes a first weighting parameter k' corresponding to each second dataset in the N second datasets. The second data includes an $i^{th}$ first sub-dataset obtained by performing weighted encoding on an $i^{th}$ second dataset based on the first weighting parameter $k_i'$, and the $i^{th}$ first sub-dataset expresses the $i^{th}$ second dataset based on $k_i'$ basis vectors in the dictionary matrix.

In a possible implementation, the first weighting parameter $k_i'$ is determined based on a data feature of the $i^{th}$ second dataset.

In a possible implementation, the dictionary matrix includes N dictionary submatrices respectively corresponding to the N second datasets, and the N dictionary submatrices include at least two different dictionary submatrices.

In a possible implementation, the first weighting parameter $k_i'$ corresponding to the $i^{th}$ second dataset includes a second weighting parameter $k_i''$ corresponding to each first dataset in the $i^{th}$ second dataset. The $i^{th}$ first sub-dataset includes a $j^{th}$ piece of subdata obtained by performing weighted encoding on a $j^{th}$ first dataset in the $i^{th}$ second dataset based on the second weighting parameter $k_{ij}''$, and the $j^{th}$ piece of subdata in the $i^{th}$ first sub-dataset expresses the $j^{th}$ first dataset in the $i^{th}$ second dataset based on $k_{ij}''$ basis vectors in an $i^{th}$ dictionary submatrix corresponding to the $i^{th}$ second dataset.

In a possible implementation, the second weighting parameter $k_{ij}''$ corresponding to the $j^{th}$ first dataset in the $i^{th}$ second dataset is determined based on a data feature of the $j^{th}$ first dataset in the $i^{th}$ second dataset.

In a possible implementation, K basis vectors in third data include $K_i'$ basis vectors corresponding to the $i^{th}$ second dataset, the third data is obtained by performing weighted encoding on each second dataset in the first data, the K basis vectors include the k basis vectors, and the $k_i'$ basis vectors in the $i^{th}$ second dataset are first $k_i'$ basis vectors that are in the $K_i'$ basis vectors and that are in descending order of capabilities of expressing the first data.

In a possible implementation, the method further includes: The second communication apparatus receives P pieces of incremental data that are sent by the first communication apparatus and that are of the second data, where P is an integer greater than or equal to 1. A $q^{th}$ piece of incremental data in the P pieces of incremental data includes an $i^{th}$ piece of first subdata, and the $i^{th}$ piece of first subdata expresses the $i^{th}$ second dataset based on $h_{(q, i)}$ basis vectors in the $i^{th}$ dictionary submatrix in the dictionary matrix, where $h_{(q, i)}$ is an integer less than K and greater than or equal to 1. The $q^{th}$ piece of incremental data is subdata of the third data, and the $i^{th}$ piece of first subdata includes location indication information and weighting coefficients of the $h_{(q, i)}$ basis vectors in the third data. Alternatively, a $q^{th}$ piece of incremental data is subdata of fourth data. The $i^{th}$ piece of first subdata includes weighting coefficients of $k_i'$ basis vectors in the fourth data and/or a basis vector in at least one of first q-1 pieces of incremental data in the P pieces of incremental data, and location indication information and weighting coefficients of the $h_{(q, i)}$ basis vectors in the fourth data. The fourth data is determined based on the $i^{th}$ dictionary submatrix, the first data, and fourth data corresponding to a $(q-1)^{th}$ piece of incremental data. When q is equal to 1, the fourth data corresponding to the $(q-1)^{th}$ piece of incremental data is the second

$$\sum_{i=1}^{N}\sum_{q=1}^{P}h_{(q,i)} \qquad \sum_{i=1}^{N}k_i'$$

data. A sum of quantities $\sum_{i=1}^{N}\sum_{q=1}^{P}h_{(q,i)}$ and $\sum_{i=1}^{N}k_i'$ of basis vectors in the P pieces of incremental data is less than or equal to K.

In a possible implementation, the third data expresses the first data based on the K basis vectors in the dictionary matrix, and the third data is obtained by performing weighted encoding on the first data.

In a possible implementation, the k basis vectors are first k basis vectors that are in the K basis vectors in the dictionary matrix and that are in descending order of capabilities of expressing the first data.

In a possible implementation, the method further includes: The second communication apparatus receives P pieces of incremental data that are sent by the first communication apparatus and that are of the second data, where P is an integer greater than or equal to 1. A $q^{th}$ piece of incremental data in the P pieces of incremental data is subdata of the third data, and the $q^{th}$ piece of incremental data includes location indication information and weighting coefficients of $h_q$ basis vectors in the third data. Alternatively, a $q^{th}$ piece of incremental data in the P pieces of incremental data is subdata of fourth data. The $q^{th}$ piece of incremental data includes weighting coefficients of the k basis vectors in the fourth data and/or a weighting coefficient of a basis vector in at least one of first q-1 pieces of incremental data in the P pieces of incremental data, and location indication information and weighting coefficients of $h_q$ basis vectors in the fourth data. The fourth data is determined based on the dictionary matrix, the first data, and fourth data corresponding to a $(q-1)^{th}$ piece of incremental data. When q is equal to 1, the fourth data corresponding to the $(q-1)^{th}$ piece of incremental data is the second data. $h_q$ is an integer less than K and greater than or equal to 1, and a sum of a quantity $\sum_{q=1}^{P}h_q$ of basis vectors in the P pieces of incremental data and k is less than or equal to K.

In a possible implementation, the $h_q$ basis vectors are first $h_q$ basis vectors that are other than the k basis vectors in the K basis vectors and $\sum_{r=1}^{q-1}h_r$ basis vectors in the first q-1 pieces of incremental data and that are in descending order of capabilities of expressing the first data, where $h_r$ is a quantity of basis vectors in one of the first q-1 pieces of incremental data.

In a possible implementation, the second data includes location indication information and/or the weighting coefficients of the k basis vectors.

In a possible implementation, that a second communication apparatus receives, on a first transmission resource, second data from a first communication apparatus includes: The second communication apparatus receives, on the first transmission resource, compressed data that is sent by the first communication apparatus and that is of the second data. The compressed data of the second data is obtained by performing quantization and/or entropy encoding on the second data. The second communication apparatus decompresses the compressed data of the second data to obtain the second data.

In a possible implementation, the method further includes: The second communication apparatus receives the dictionary matrix sent by the first communication apparatus.

In a possible implementation, the second communication apparatus may receive a quantized and/or entropy-encoded dictionary matrix sent by the first communication apparatus, and decompress the quantized and/or entropy-encoded dictionary matrix to restore the dictionary matrix obtained before quantization and/or entropy encoding are/is performed.

In a possible implementation, a data feature of the first dataset or the second dataset includes at least one of a data amount, data boundary values, and a mean variance.

In a possible implementation, the method further includes: The second communication apparatus receives category indication information sent by the first communication apparatus, where the category indication information indicates a clustering category of each of the M first datasets.

In a possible implementation, the second communication apparatus receives indication information that is sent by the first communication apparatus and that is of a second transmission resource, and the second transmission resource is used to transmit incremental data of the second data.

In a possible implementation, the method further includes: The second communication apparatus receives a transmission request sent by the first communication apparatus, where the transmission request is used to request to send the incremental data of the second data.

In a possible implementation, the method further includes: The second communication apparatus sends the compression indication information to the first communication apparatus. The compression indication information includes compression hyperparameter information, the compression hyperparameter information indicates at least a target weighting parameter, the target weighting parameter is used to determine k, and the target weighting parameter is greater than or equal to k.

In a possible implementation, the method further includes: The second communication apparatus receives the compression indication information sent by the first communication apparatus. The compression indication information includes the compression hyperparameter information, the compression hyperparameter information indicates at least the target weighting parameter, the target weighting parameter is used to determine k, and the target weighting parameter is greater than or equal to k.

In a possible implementation, the compression hyperparameter information includes at least one of the following:

configuration information of the first transmission resource, where the first transmission resource indicates the target weighting parameter; and
information indicating a dimension of a basis vector and/or a quantity of basis vectors in the dictionary matrix.

In a possible implementation, the compression indication information further includes at least one of the following:

information indicating a clustering manner of the M first datasets in the first data;
information indicating a compression manner of one or more of the N second datasets in the first data; and
information indicating whether to perform entropy encoding on the second data.

In a possible implementation, the method further includes: The second communication apparatus receives compression parameter information sent by the first communication apparatus, where the compression parameter information includes at least one of the following:

boundary values of the dictionary matrix; and
boundary values of the weighting coefficients of the basis vectors in the second data.

In a possible implementation, the method further includes: The second communication apparatus receives feedback information sent by the first communication apparatus, where the feedback information includes a weighting parameter $k_m$, and the weighting parameter $k_m$ is used to adjust a size of a transmission resource in a next round.

For beneficial effect of the data compression and transmission method provided in the second aspect and the possible implementations of the second aspect, refer to beneficial effect achieved by the first aspect and the possible implementations of the first aspect. Details are not described herein again.

According to a third aspect, an embodiment of this application provides a communication apparatus, including: a processing module, configured to perform weighted encoding on first data based on a dictionary matrix, to obtain second data, where the second data expresses the first data based on k basis vectors in the dictionary matrix, k is a weighting parameter that is determined based on a first transmission resource and that is of the first data, and k is an integer greater than or equal to 1; and a transceiver module, configured to send the second data to a second communication apparatus on the first transmission resource.

In a possible implementation, the first data includes M first datasets, the M first datasets are clustered into N second datasets, the second dataset includes at least one first dataset, and M and N are both integers greater than or equal to 1.

In a possible implementation, the weighting parameter k of the first data includes a first weighting parameter $k_i'$ corresponding to an $i^{th}$ second dataset in the N second datasets. The second data includes an $i^{th}$ first sub-dataset obtained by performing weighted encoding on the $i^{th}$ second dataset based on the first weighting parameter $k_i'$, and the $i^{th}$ first sub-dataset expresses the $i^{th}$ second dataset based on $k_i'$ basis vectors in the dictionary matrix.

In a possible implementation, the first weighting parameter $k_i'$ is determined based on a data feature of the $i^{th}$ second dataset.

In a possible implementation, the dictionary matrix includes N dictionary submatrices respectively corresponding to the N second datasets, and the N dictionary submatrices include at least two different dictionary submatrices.

In a possible implementation, the first weighting parameter $k_i'$ corresponding to the $i^{th}$ second dataset includes a second weighting parameter $k_i''$ corresponding to each first dataset in the $i^{th}$ second dataset. The $i^{th}$ first sub-dataset includes a $j^{th}$ piece of subdata obtained by performing weighted encoding on a $j^{th}$ first dataset in the $i^{th}$ second dataset based on the second weighting parameter $k_{ij}''$, and the $j^{th}$ piece of subdata in the $i^{th}$ first sub-dataset expresses the $j^{th}$ first dataset in the $i^{th}$ second dataset based on $k_{ij}''$ basis vectors in an $i^{th}$ dictionary submatrix corresponding to the $i^{th}$ second dataset.

In a possible implementation, the second weighting parameter $k_{ij}''$ corresponding to the $j^{th}$ first dataset in the $i^{th}$ second dataset is determined based on a data feature of the $j^{th}$ first dataset in the $i^{th}$ second dataset.

In a possible implementation, K basis vectors in third data include $K_i'$ basis vectors corresponding to the $i^{th}$ second dataset, the third data is obtained by performing weighted encoding on each second dataset in the first data, the K basis vectors include the k basis vectors, and the $k_i'$ basis vectors in the $i^{th}$ second dataset are first $k_i'$ basis vectors that are in the $K_i'$ basis vectors and that are in descending order of capabilities of expressing the first data.

In a possible implementation, the transceiver module is further configured to send P pieces of incremental data of the second data to the second communication apparatus, where P is an integer greater than or equal to 1. A $q^{th}$ piece of incremental data in the P pieces of incremental data includes an $i^{th}$ piece of first subdata, and the $i^{th}$ piece of first subdata expresses the $i^{th}$ second dataset based on $h_{(q, i)}$ basis vectors in the $i^{th}$ dictionary submatrix in the dictionary matrix, where $h_{(q, i)}$ is an integer less than K and greater than or equal to 1. The $q^{th}$ piece of incremental data is subdata of the third data, and the $i^{th}$ piece of first subdata includes location indication information and weighting coefficients of the $h_{(q, i)}$ basis vectors in the third data. Alternatively, a $q^{th}$ piece of incremental data is subdata of fourth data. The $i^{th}$ piece of first subdata includes weighting coefficients of $k_i'$ basis vectors in the fourth data and/or a basis vector in at least one of first q-1 pieces of incremental data in the P pieces of incremental data, and location indication information and weighting coefficients of the $h_{(q, i)}$ basis vectors in the fourth data. The fourth data is determined based on the $i^{th}$ dictionary submatrix, the first data, and fourth data corresponding to a $(q-1)^{th}$ piece of incremental data. When q is equal to 1, the fourth data corresponding to the

$$\sum_{i=1}^{N}\sum_{q=1}^{P} h_{(q,i)} \qquad \sum_{i=1}^{N} k_i'$$

$(q-1)^{th}$ piece of incremental data is the second data. A sum of quantities $\sum_{i=1}^{N}\sum_{q=1}^{P} h_{(q,i)}$ and $\sum_{i=1}^{N} k_i'$ of basis vectors in the P pieces of incremental data is less than or equal to K.

In a possible implementation, the processing module is further configured to perform weighted encoding on the first data to obtain the dictionary matrix and third data. The third data expresses the first data based on K basis vectors in the dictionary matrix, the K basis vectors include the k basis vectors, and K is an integer greater than or equal to k.

In a possible implementation, the k basis vectors are first k basis vectors that are in the K basis vectors in the dictionary matrix and that are in descending order of capabilities of expressing the first data.

In a possible implementation, the transceiver module is further configured to send P pieces of incremental data of the second data to the second communication apparatus, where P is an integer greater than or equal to 1. A $q^{th}$ piece of incremental data in the P pieces of incremental data is subdata of the third data, and the $q^{th}$ piece of incremental data includes location indication information and weighting coefficients of $h_q$ basis vectors in the third data. Alternatively, a $q^{th}$ piece of incremental data in the P pieces of incremental data is subdata of fourth data. The $q^{th}$ piece of incremental data includes weighting coefficients of the k basis vectors in the fourth data and/or a weighting coefficient of a basis vector in at least one of first q-1 pieces of incremental data in the P pieces of incremental data, and location indication information and weighting coefficients of $h_q$ basis vectors in the fourth data. The fourth data is determined based on the dictionary matrix, the first data, and fourth data corresponding to a $(q-1)^{th}$ piece of incremental data. When q is equal to 1, the fourth data corresponding to the $(q-1)^{th}$ piece of incremental data is the second data. $h_q$ is an integer less than K and greater than or

$$\sum_{q=1}^{P} h_q$$

equal to 1, and a sum of a quantity $\sum_{q=1}^{P} h_q$ of basis vectors in the P pieces of incremental data and k is less than or equal to K.

In a possible implementation, the $h_q$ basis vectors are first $h_q$ basis vectors that are other than the k basis vectors

$$\sum_{r=1}^{q-1} h_r$$

in the K basis vectors and $\sum_{r=1}^{q-1} h_r$ basis vectors in the first q-1 pieces of incremental data and that are in descending order of capabilities of expressing the first data, where $h_r$ is a quantity of basis vectors in one of the first q-1 pieces of incremental data.

In a possible implementation, the second data includes location indication information and/or the weighting coefficients of the k basis vectors.

In a possible implementation, the processing module is further configured to perform quantization and/or entropy encoding on the second data, to obtain compressed data of the second data. The transceiver module is specifically configured to send the compressed data of the second data to the second communication apparatus on the first transmission resource.

In a possible implementation, the transceiver module is further configured to send the dictionary matrix to the second communication apparatus.

In a possible implementation, the processing module performs quantization and/or entropy encoding on the dictionary matrix, and the transceiver module sends, to the second communication apparatus, a quantized and/or entropy-encoded dictionary matrix.

In a possible implementation, a data feature of the first dataset or the second dataset includes at least one of a data amount, data boundary values, and a mean variance.

In a possible implementation, the transceiver module is further configured to cluster the M first datasets based on one of the following, to obtain the N second datasets:

data types of the M first datasets; and
boundary values of elements in the M first datasets.

In a possible implementation, the transceiver module is further configured to send category indication information to the second communication apparatus, where the category indication information indicates a clustering category of each of the M first datasets.

In a possible implementation, the transceiver module is further configured to receive indication information that is sent by the second communication apparatus and that is of a second transmission resource, and the second transmission resource is used to transmit incremental data of the second data.

In a possible implementation, the transceiver module is further configured to send a transmission request to the second communication apparatus, where the transmission request is used to request to send the incremental data of the second data.

In a possible implementation, the transceiver module is further configured to receive compression indication information sent by the second communication apparatus. The compression indication information includes compression hyperparameter information, the compression hyperparameter information indicates at least a target weighting parameter, the target weighting parameter is used to determine k, and the target weighting parameter is greater than or equal to k.

In a possible implementation, the transceiver module is further configured to send the compression indication information to the second communication apparatus. The compression indication information includes the compression hyperparameter information, the compression hyperparameter information indicates at least the target weighting parameter, the target weighting parameter is used to determine k, and the target weighting parameter is greater than or equal to k.

In a possible implementation, the compression hyperparameter information includes at least one of the following:

configuration information of the first transmission resource, where the first transmission resource indicates the target weighting parameter; and
information indicating a dimension of a basis vector and/or a quantity of basis vectors in the dictionary matrix.

In a possible implementation, the compression indication information further includes at least one of the following:

information indicating a clustering manner of the M first datasets in the first data;
information indicating a compression manner of one or more of the N second datasets in the first data; and
information indicating whether to perform entropy encoding on the second data.

In a possible implementation, the processing module is further configured to determine the compression manner of the one or more of the N second datasets based on a data feature of the first data.

In a possible implementation, the transceiver module is further configured to send compression parameter information to the second communication apparatus, where the compression parameter information includes at least one of the following:

boundary values of the dictionary matrix; and
boundary values of the weighting coefficients of the basis vectors in the second data.

In a possible implementation, the transceiver module is further configured to send feedback information to the second communication apparatus, where the feedback information includes a weighting parameter $k_m$, and the weighting parameter $k_m$ is used to adjust a size of a transmission resource in a next round.

For beneficial effect of the communication apparatus provided in the third aspect and the possible implementations of the third aspect, refer to beneficial effect achieved by the first aspect and the possible implementations of the first aspect. Details are not described herein again.

According to a fourth aspect, an embodiment of this application provides a communication apparatus, including: a transceiver module, configured to receive, on a first transmission resource, second data from a first communication apparatus, where the second data expresses first data based on k basis vectors in a dictionary matrix, k is a weighting parameter that is determined based on the first transmission resource and that is of the first data, and k is an integer greater than or equal to 1; and a processing module, configured to construct the first data based on the second data and the dictionary matrix.

In a possible implementation, the first data includes M first datasets, the M first datasets are clustered into N second datasets, the second dataset includes at least one first dataset, and M and N are both integers greater than or equal to 1.

In a possible implementation, the weighting parameter k of the first data includes a first weighting parameter k' corresponding to each second dataset in the N second datasets. The second data includes an $i^{th}$ first sub-dataset obtained by performing weighted encoding on an $i^{th}$ second dataset based on the first weighting parameter $k_i'$, and the $i^{th}$ first sub-dataset expresses the $i^{th}$ second dataset based on $k_i'$ basis vectors in the dictionary matrix.

In a possible implementation, the first weighting parameter $k_i'$ is determined based on a data feature of the $i^{th}$ second dataset.

In a possible implementation, the dictionary matrix includes N dictionary submatrices respectively corresponding to the N second datasets, and the N dictionary submatrices include at least two different dictionary submatrices.

In a possible implementation, the first weighting parameter $k_i'$ corresponding to the $i^{th}$ second dataset includes a second weighting parameter $k_i''$ corresponding to each first dataset in the $i^{th}$ second dataset. The $i^{th}$ first sub-dataset includes a $j^{th}$ piece of subdata obtained by performing weighted encoding on a $j^{th}$ first dataset in the $i^{th}$ second dataset based on the second weighting parameter $k_{ij}''$, and the $j^{th}$ piece of subdata in the $i^{th}$ first sub-dataset expresses the $j^{th}$ first dataset in the $i^{th}$ second dataset based on $k_{ij}''$ basis vectors in an $i^{th}$ dictionary submatrix corresponding to the $i^{th}$ second dataset.

In a possible implementation, the second weighting parameter $k_{ij}''$ corresponding to the $j^{th}$ first dataset in the $i^{th}$ second dataset is determined based on a data feature of the $j^{th}$ first dataset in the $i^{th}$ second dataset.

In a possible implementation, K basis vectors in third data include $K_i'$ basis vectors corresponding to the $i^{th}$ second dataset, the third data is obtained by performing weighted encoding on each second dataset in the first data, the K basis vectors include the k basis vectors, and the $k_i'$ basis vectors in the $i^{th}$ second dataset are first $k_i'$ basis vectors that are in the $K_i'$ basis vectors and that are in descending order of capabilities of expressing the first data.

In a possible implementation, the transceiver module is further configured to receive P pieces of incremental data that are sent by the first communication apparatus and that are of the second data, where P is an integer greater than or equal to 1. A $q^{th}$ piece of incremental data in the P pieces of incremental data includes an $i^{th}$ piece of first subdata, and the $i^{th}$ piece of first subdata expresses the $i^{th}$ second dataset based on $h_{(q, i)}$ basis vectors in the $i^{th}$ dictionary submatrix in the dictionary matrix, where $h_{(q, i)}$ is an integer less than K and greater than or equal to 1. The $q^{th}$ piece of incremental data is subdata of the third data, and the $i^{th}$ piece of first subdata includes location indication information and weighting coefficients of the $h_{(q, i)}$ basis vectors in the third data. Alternatively, a $q^{th}$ piece of incremental data is subdata of fourth data. The $i^{th}$ piece of first subdata includes weighting coefficients of $k_i'$ basis vectors in the fourth data and/or a basis vector in at least one of first q-1 pieces of incremental data in the P pieces of incremental data, and location indication information and weighting coefficients of the $h_{(q, i)}$ basis vectors in the fourth data. The fourth data is determined based on the $i^{th}$ dictionary submatrix, the first data, and fourth data corresponding to a $(q-1)^{th}$ piece of incremental data. When q is equal to 1, the fourth data corresponding to the $(q-1)^{th}$ piece of incremental data is the second data. A sum of quantities $\displaystyle\sum_{i=1}^{N}\sum_{q=1}^{P}h_{(q,i)}$ and $\displaystyle\sum_{i=1}^{N}k_i'$ of basis vectors in the P pieces of incremental data is less than or equal to K.

In a possible implementation, the third data expresses the first data based on the K basis vectors in the dictionary matrix, and the third data is obtained by performing weighted encoding on the first data.

In a possible implementation, the k basis vectors are first k basis vectors that are in the K basis vectors in the dictionary matrix and that are in descending order of capabilities of expressing the first data.

In a possible implementation, the transceiver module is further configured to receive P pieces of incremental data that are sent by the first communication apparatus and that are of the second data, where P is an integer greater than or equal to 1. A $q^{th}$ piece of incremental data in the P pieces of incremental data is subdata of the third data, and the $q^{th}$ piece of incremental data includes location indication information and weighting coefficients of $h_q$ basis vectors in the third data. Alternatively, a $q^{th}$ piece of incremental data in the P pieces of incremental data is subdata of fourth data. The $q^{th}$ piece of incremental data includes weighting coefficients of the k basis vectors in the fourth data and/or a weighting coefficient of a basis vector in at least one of first q-1 pieces of incremental data in the P pieces of incremental data, and location indication information and weighting coefficients of $h_q$ basis vectors in the fourth data. The fourth data is determined based on the dictionary matrix, the first data, and fourth data corresponding to a $(q-1)^{th}$ piece of incremental data. When q is equal to 1, the fourth data corresponding to the $(q-1)^{th}$ piece of incremental data is the second data. $h_q$ is an integer less than K and

$$\sum_{q=1}^{P} h_q$$

greater than or equal to 1, and a sum of a quantity $\sum_{q=1}^{P} h_q$ of basis vectors in the P pieces of incremental data and k is less than or equal to K.

In a possible implementation, the $h_q$ basis vectors are first $h_q$ basis vectors that are other than the k basis vectors

$$\sum_{r=1}^{q-1} h_r$$

in the K basis vectors and $\sum_{r=1}^{q-1} h_r$ basis vectors in the first q-1 pieces of incremental data and that are in descending order of capabilities of expressing the first data, where $h_r$ is a quantity of basis vectors in one of the first q-1 pieces of incremental data.

In a possible implementation, the second data includes location indication information and/or the weighting coefficients of the k basis vectors.

In a possible implementation, the transceiver module is further configured to receive, on the first transmission resource, compressed data that is sent by the first communication apparatus and that is of the second data. The compressed data of the second data is obtained by performing quantization and/or entropy encoding on the second data. The processing module is further configured to decompress the compressed data of the second data to obtain the second data.

In a possible implementation, the transceiver module is further configured to receive the dictionary matrix sent by the first communication apparatus.

In a possible implementation, the transceiver module receives a quantized and/or entropy-encoded dictionary matrix sent by the first communication apparatus, and the processing module decompresses the quantized and/or entropy-encoded dictionary matrix to restore the dictionary matrix obtained before quantization and/or entropy encoding are/is performed.

In a possible implementation, a data feature of the first dataset or the second dataset includes at least one of a data amount, data boundary values, and a mean variance.

In a possible implementation, the transceiver module is further configured to receive category indication information sent by the first communication apparatus, where the category indication information indicates a clustering category of each of the M first datasets.

In a possible implementation, the transceiver module is further configured to receive indication information that is sent by the first communication apparatus and that is of a second transmission resource, and the second transmission resource is used to transmit incremental data of the second data.

In a possible implementation, the transceiver module is further configured to receive a transmission request sent by the first communication apparatus, where the transmission request is used to request to send the incremental data of the second data.

In a possible implementation, the transceiver module is further configured to send the compression indication information to the first communication apparatus. The compression indication information includes compression hyperparameter information, the compression hyperparameter information indicates at least a target weighting parameter, the target weighting parameter is used to determine k, and the target weighting parameter is greater than or equal to k.

In a possible implementation, the transceiver module is further configured to receive the compression indication information sent by the first communication apparatus. The compression indication information includes the compression hyperparameter information, the compression hyperparameter information indicates at least the target weighting parameter, the target weighting parameter is used to determine k, and the target weighting parameter is greater than or equal to k.

In a possible implementation, the compression hyperparameter information includes at least one of the following:

configuration information of the first transmission resource, where the first transmission resource indicates the target weighting parameter; and
information indicating a dimension of a basis vector and/or a quantity of basis vectors in the dictionary matrix.

In a possible implementation, the compression indication information further includes at least one of the following:

information indicating a clustering manner of the M first datasets in the first data;
information indicating a compression manner of one or more of the N second datasets in the first data; and
information indicating whether to perform entropy encoding on the second data.

In a possible implementation, the transceiver module is further configured to receive compression parameter information sent by the first communication apparatus, where the compression parameter information includes at least one of the following:

boundary values of the dictionary matrix; and

boundary values of the weighting coefficients of the basis vectors in the second data.

In a possible implementation, the transceiver module is further configured to receive feedback information sent by the first communication apparatus, where the feedback information includes a weighting parameter $k_m$, and the weighting parameter $k_m$ is used to adjust a size of a transmission resource in a next round.

For beneficial effect of the communication apparatus provided in the fourth aspect and the possible implementations of the fourth aspect, refer to beneficial effect achieved by the first aspect and the possible implementations of the first aspect. Details are not described herein again.

According to a fifth aspect, an embodiment of this application provides a communication apparatus, including: a processor, configured to perform the method in any one of the first aspect, the second aspect, or the possible implementations of the first aspect and the second aspect by running a computer program or by using a logic circuit.

In a possible implementation, the communication apparatus further includes a memory, and the memory is configured to store the computer program.

In a possible implementation, the communication apparatus further includes a communication interface, and the communication interface is configured to input and/or output a signal.

According to a sixth aspect, an embodiment of this application provides a communication system, including a first communication apparatus configured to perform the method in any one of the first aspect or the possible implementations of the first aspect, and a second communication apparatus configured to perform the method in any one of the second aspect or the possible implementations of the second aspect.

According to a seventh aspect, an embodiment of this application provides a computer-readable storage medium, configured to store computer program instructions. The computer program enables a computer to perform the method in any one of the first aspect, the second aspect, or the possible implementations of the first aspect and the second aspect.

According to an eighth aspect, an embodiment of this application provides a computer program product, including computer program instructions. The computer program instructions enable a computer to perform the method in any one of the first aspect, the second aspect, or the possible implementations of the first aspect and the second aspect.

According to a ninth aspect, an embodiment of this application provides a computer program. The computer program enables a computer to perform the method in any one of the first aspect, the second aspect, or the possible implementations of the first aspect and the second aspect.

**BRIEF DESCRIPTION OF DRAWINGS**

FIG. 1 is a diagram of an architecture of a mobile communication system to which an embodiment of this application is applied;

FIG. 2 is a diagram of a framework of data compression and transmission according to an embodiment of this application;

FIG. 3 is a diagram of dictionary learning according to an embodiment of this application;

FIG. 4 is a schematic interaction flowchart of a data compression and transmission method according to an embodiment of this application;

FIG. 5 is a diagram of a framework of data compression and transmission according to an embodiment of this application;

FIG. 6 is a diagram of a framework of data compression and transmission according to an embodiment of this application;

FIG. 7 is a diagram of a clustering category according to an embodiment of this application;

FIG. 8 is a diagram of a framework of data compression and transmission according to an embodiment of this application;

FIG. 9 is a diagram of layered incremental transmission according to an embodiment of this application;

FIG. 10a is a schematic interaction flowchart of a data compression and transmission method according to an embodiment of this application;

FIG. 10b is a schematic interaction flowchart of a data compression and transmission method according to an embodiment of this application;

FIG. 10c is a schematic interaction flowchart of a data compression and transmission method according to an embodiment of this application;

FIG. 10d is a schematic interaction flowchart of a data compression and transmission method according to an embodiment of this application;

FIG. 11 is a block diagram of a communication apparatus according to an embodiment of this application; and

FIG. 12 is another block diagram of a communication apparatus according to an embodiment of this application.

## DESCRIPTION OF EMBODIMENTS

The following describes technical solutions of this application with reference to accompanying drawings.

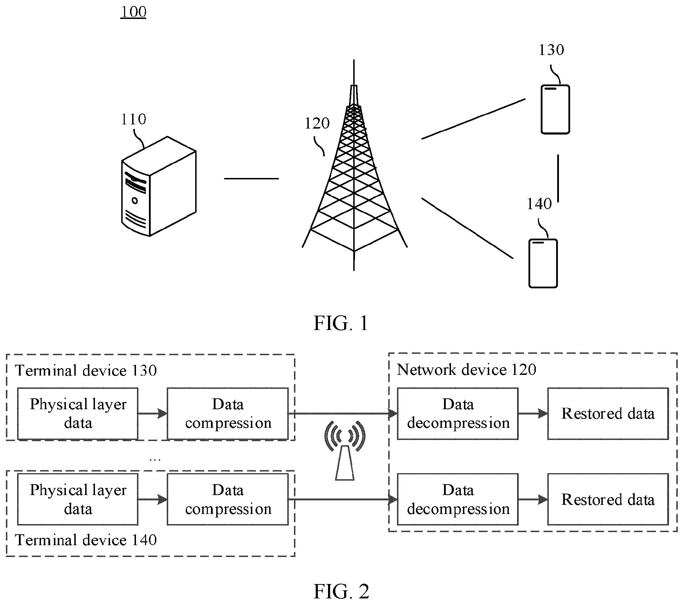

FIG. 1 is a diagram of an architecture of a mobile communication system to which an embodiment of this application is applied. As shown in FIG. 1, the mobile communication system includes a core network device 110, a network device 120, and at least one terminal device (a terminal device 130 and a terminal device 140 shown in FIG. 1). The terminal device is connected to the network device in a wireless manner, and the network device is connected to the core network device in a wireless manner or a wired manner. The core network device and the network device may be different physical devices independent of each other; functions of the core network device and logical functions of the network device may be integrated into a same physical device; or some functions of the core network device and some functions of the network device may be integrated into one physical device. The terminal device may be located at a fixed location, or may be mobile. FIG. 1 is only the diagram. The communication system may further include another network device, for example, may further include a wireless relay device and a wireless backhaul device, which are not shown in FIG. 1. Quantities of core network devices, network devices, and terminal devices included in the mobile communication system are not limited in embodiments of this application.

In embodiments of this application, a network device may be any device with a wireless transceiver function. The network device includes but is not limited to: an evolved NodeB (evolved NodeB, eNB), a home base station (for example, a home evolved NodeB, or a home NodeB, HNB), a baseband unit (baseband unit, BBU), an access point (access point, AP) in a wireless fidelity (wireless fidelity, Wi-Fi) system, a wireless relay node, a wireless backhaul node, a transmission point (transmission point, TP), or a transmission reception point (transmission reception point, TRP). Alternatively, the network device may be a mobile switching center, a device that undertakes a base station function in device-to-device (Device-to-Device, D2D), vehicle-to-everything (vehicle-to-everything, V2X), or machine-to-machine (machine-to-machine, M2M) communication, or the like. Alternatively, the network device may be a gNB in a 5G system, or one or a group of (including a plurality of antenna panels) antenna panels of a base station in a 5G system. Alternatively, the network device may be a network node that constitutes a gNB or a transmission point, for example, a BBU or a distributed unit (distributed unit, DU). This is not specifically limited in embodiments of this application.

In some deployments, a gNB may include a central unit (central unit, CU) and a DU. The CU and the DU separately implement some functions of the gNB, and the CU and the DU may communicate with each other through an F1 interface. The gNB may further include an active antenna unit (active antenna unit, AAU). The AAU may implement some physical layer processing functions, radio frequency processing, and a function related to an active antenna.

It may be understood that the network device may be a device including one or more of a CU node, a DU node, and an AAU node. In addition, the CU may be classified into a network device in an access network (radio access network, RAN), or the CU may be classified into a network device in a core network (core network, CN). This is not limited in this application.

In embodiments of this application, the terminal device may also be referred to as user equipment (user equipment, UE), an access terminal, a subscriber unit, a subscriber station, a mobile station, a mobile console, a remote station, a remote terminal, a mobile device, a user terminal, a terminal, a wireless communication device, a user agent, or a user apparatus.

The terminal device may be a device that provides voice/data connectivity for a user, for example, a handheld device or a vehicle-mounted device that has a wireless connection function. Currently, some examples of the terminal may be: a mobile phone (mobile phone), a tablet computer (pad), a computer with a wireless transceiver function (such as a notebook computer or a palmtop computer), a customer-premises equipment (customer premises equipment, CPE), a smart point of sale (point of sale, POS) machine, a mobile internet device (mobile internet device, MID), a virtual reality (virtual reality, VR) device, an augmented reality (augmented reality, AR) device, a wireless terminal in industrial control (industrial control), a wireless terminal in self driving (self driving), a wireless terminal in remote medical (remote medical), a wireless terminal in a smart grid (smart grid), a wireless terminal in transportation safety (transportation safety), a wireless terminal in a smart city (smart city), a wireless terminal in a smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a computing device or another processing device connected to a wireless modem, a vehicle-mounted device, a wearable device, a terminal device in a 5G network, a terminal device in a system evolved after 5G, or the like.

The network device and the terminal device may communicate with each other over a licensed spectrum (licensed spectrum), or may communicate with each other over an unlicensed spectrum (unlicensed spectrum), or may communicate with each other over both a licensed spectrum and an unlicensed spectrum. The network device and the terminal device may communicate with each other on a spectrum below 6G, may communicate with each other on a spectrum above 6G, or may communicate with each other on both a spectrum below 6G and a spectrum above 6G. A spectrum resource used between the network device and the terminal device is not limited in embodiments of this application.

It should be understood that specific forms of the network device and the terminal device are not limited in this application.

A communication method provided in this application may be applied to various communication systems, for example, a long term evolution (Long Term Evolution, LTE) system, a 5G mobile communication system, a 6G mobile communication system that is evolved after 5G. The 5G mobile communication system or the 6G mobile communication system may include non-standalone (non-standalone, NSA) networking and/or standalone (standalone, SA) networking.

The communication method provided in this application may be further applied to machine type communication (machine type communication, MTC), a long term evolution-machine technology (Long Term Evolution-machine, LTE-M), a device-to-device (device-to-device, D2D) network, a machine-to-machine (machine-to-machine, M2M) network, an internet of things (internet of things, IoT) network, or another network.

A federated learning (federated learning) scenario is used as an example. The federated learning is a distributed machine learning technology in which distributed model training is performed between a plurality of data sources with local data, and a global model is constructed based on virtual convergent data by only iteratively interacting model parameters or intermediate results without exchanging local individuals or sample data, thereby achieving a balance between data privacy protection and data sharing and computing. In the federated learning scenario, the terminal device (for example, 130 and/or 140 in FIG. 1) may transmit a locally updated model parameter or an intermediate result to the network device (for example, 120 in FIG. 1) to update global AI model data.

In the communication system shown in FIG. 1, for a process of performing data compression and transmission between devices, refer to a diagram of a framework of data compression and transmission shown in FIG. 2. As shown in FIG. 2, the terminal devices 130 and 140 may separately perform local model learning to obtain local physical layer data, perform data compression on the local physical layer data, and send compressed data to the network device 120. The network device 120 separately performs data decompression on the received compressed data of the terminal devices, and performs data restoration for the terminal devices to obtain the restored data.

In each iteration process, a physical layer of a communication device generates a very large parameter data amount. For example, a parameter amount of a common residual network (resnet) 18 model reaches a data amount level of tens of millions of data, and frequent interaction is required, which occupies a large quantity of communication resources. Therefore, each communication device needs to compress data during data transmission at each time, to improve communication efficiency.

Communication efficiency of native data transmission at the physical layer is considered, a common compression manner is a combination of scalar quantization and entropy encoding. However, compression performance of the method is limited, and a larger compression ratio cannot be implemented on a premise of ensuring a low data loss.

To implement effective and reliable data compression and transmission, in embodiments of this application, weighted encoding is performed on to-be-transmitted data based on dictionary learning, to express the to-be-transmitted data based on k basis vectors, so that physical layer data is compressed while a low data loss is ensured. Further, a weighting parameter k used to perform weighted encoding on the to-be-transmitted data is determined based on a transmission resource for compression and transmission, so that a balance between the transmission resource and compression performance is implemented, to avoid a case in which when transmission resources are sufficient, a large amount of transmitted data is lost due to excessive compression, or a case in which when transmission resources are insufficient, the compressed data cannot be transmitted due to a large amount of compressed data. Effective and reliable data compression is performed on a large amount of to-be-transmitted data.

It should be noted that the foregoing example is described by using only an example in which uplink transmission is performed on AI model data, but should not be construed as any limitation on this application. For example, in the federated learning scenario, the network device (for example, 120 in FIG. 1) may transmit locally updated AI model data to the terminal device (for example, 130 and/or 140 in FIG. 1) in a downlink manner, or a terminal device A (for example, 130 in FIG. 1) may transmit locally updated AI model data to a terminal device B (for example, 140 in FIG. 1) in a sidelink manner.

In embodiments of this application, performing data restoration on first data may be represented as performing data construction on the first data, and meanings of performing data restoration on the first data and performing data construction on the first data may be consistent. In addition, for ease of description, meanings may also be consistent after a word order is changed. For example, the foregoing description may be replaced with restoring the first data or constructing the first data.

For ease of understanding this application, the dictionary learning is first described as an example.

A q-dimensional (q is greater than or equal to 1) weighted encoding method based on the dictionary learning: A dictionary matrix D including a group of basis vectors (or referred to as atoms), optimal q atom combinations representing sample vectors y, and a corresponding weighting coefficient X are learned based on a sample vector set Y. In other words, all sample vectors in the sample set are represented as a linear combination of q basis vectors in the dictionary matrix D.

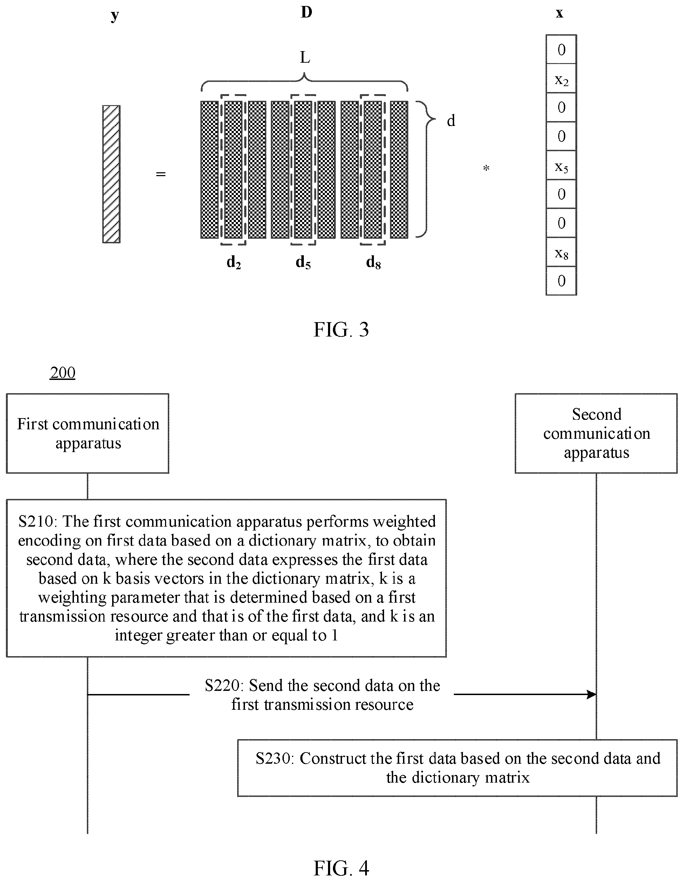

FIG. 3 is a diagram of dictionary learning according to an embodiment of this application. As shown in FIG. 3, the dictionary matrix D is a d*L two-dimensional dictionary, d represents a dimension of a basis vector, and L represents a quantity of basis vectors. Each d-dimensional sample vector y of the sample vector set Y may be represented as a weighted combination of q (q is 3 in FIG. 3) basis vectors in the dictionary matrix D. In other words, in a formula y = D * x, a column vector x may be a weighting coefficient vector that is in the weighting coefficient set X corresponding to the sample vector set Y and that is used to express the sample vector y. The weighting coefficient vector x includes a zero coefficient and a non-zero coefficient. Rows in the weighting coefficient vector x one-to-one correspond to column vectors in the dictionary matrix D, and a value of a row in the weighting coefficient vector is a weighting coefficient of a corresponding basis vector. As shown in FIG. 3, y meets the following formula (1):

$$y = d_2 * x_2 + d_5 * x_5 + d_8 * x_8 \ (1)$$

A larger quantity of coefficients whose values are zero in the weighted coefficient set X indicates fewer resources occupied by information that has a low correlation with a learning task, to reduce overheads of a storage resource and a transmission resource while having a good capability of expressing the sample vector set Y. In this case, it is considered that the weighted coefficient set X has good sparse performance, that is, dictionary learning-based sparsity is good.

A compression principle of the dictionary learning is: The to-be-transmitted data is divided into m d-dimensional vectors, and the shared dictionary matrix D is learned. In this case, each d-dimensional vector may be compressed into location indication information and weighting coefficients of the k basis vectors selected in the dictionary.

In a dictionary learning process, dictionary learning may be performed based on a sample vector set (which may be replaced with to-be-transmitted data in the following, for example, first data) Y and an initialized dictionary matrix D, to obtain a learned dictionary matrix D and a learned weighted coefficient vector set (or referred to as a sparse matrix, a sparse representation, or the like) X.

The dictionary learning may include the following steps:

1. Initialize and normalize a dictionary D.
2. Fix D, set a value K of sparsity (or referred to as a weighting parameter), use an orthogonal matching pursuit (orthogonal matching pursuit, OMP) algorithm to obtain the sparse representation X of the sample vector set Y, and set an objective function being minimizing an error: E = Y - D * X. The OMP algorithm may alternatively be replaced with a matching pursuit (matching pursuit, MP) algorithm or the like. This is not limited in this application, and the weighting parameter is a quantity of basis vectors used during weighted encoding.
3. Update the dictionary matrix D and the weighted coefficient vector set X based on the target function.

If D and X are directly updated based on a singular value decomposition (singular value decomposition, SVD) result of the objective function, X is not sparse. Therefore, a term obtained by multiplying basis vectors at non-zero locations by weighting coefficients of the basis vectors is simply retained for the objective function, and performs SVD decomposition to update D and X.

4. Iterate foregoing steps 2 and 3 until the objective function converges, and obtain a converged dictionary matrix D and a converged sparse representation X.

Obtaining the sparse representation X of the sample vector set Y by using the OMP algorithm may include the following steps:

1. Perform initialization: A selected atom set P is an empty set, the sample vector set Y is obtained, and initial atom sparseness is 0.
2. Select an atom: An atom c most related to the sample vector set Y is selected based on an absolute value of an inner product of all atoms in the dictionary matrix D and the sample vector set Y, and the atom c is added to the atom set P.
3. Update a coefficient of the selected atom: The sample vector set Y represents a linear combination of atoms in the atom set P, and coefficients of the atoms are calculated by using a least square method.
4. Calculate a residual: A residual E of the selected atomic linear combination and the sample vector set Y is calculated.
5. Perform an iteration: A next iteration is performed (steps 2 and 3 are repeated, and an atom most related to the residual E continues to be selected). After a plurality of iterations are performed, the sparse representation X of the non-zero coefficient of the sample vector set Y can be obtained.

The following describes the communication method provided in embodiments of this application with reference to the accompanying drawings.

It should be understood that, merely for ease of understanding and description, the following uses interaction between a first communication apparatus and a second communication apparatus as an example to describe the method provided in embodiments of this application. When the data compression and transmission method provided in embodiments of this application is applied to uplink transmission, the first communication apparatus may be any terminal device in the communication system shown in FIG. 1, for example, the terminal device 130 or the terminal device 140, and the second communication apparatus may be the network device 120 in the communication system shown in FIG. 1. When the data compression and transmission method provided in embodiments of this application is applied to downlink transmission, the first communication apparatus may be the network device 120 in the communication system shown in FIG. 1, and the second communication apparatus may be any terminal device in the communication system shown in FIG. 1, for example, the terminal device 130 or the terminal device 140. When the data compression and transmission method provided in embodiments of this application is applied to sidelink transmission, the first communication apparatus may be any terminal device in the communication system shown in FIG. 1, for example, the terminal device 130, and the second communication apparatus may be any terminal device in the communication system shown in FIG. 1 other than the first communication apparatus, for example, the terminal device 140.

It should be further understood that this should not constitute any limitation on an execution body of the method provided in this application. Any device that can perform, by using a program that can run code of the method provided in embodiments of this application, the method provided in embodiments of this application may be used as an execution body of the method provided in embodiments of this application. For example, any one of the foregoing communication apparatuses may be implemented as a terminal device, or may be implemented as a component in a terminal device, for example, a chip, a chip system, or another functional module that can invoke a program and execute the program. Any one of the foregoing communication apparatuses may be implemented as a network device, or may be implemented as a component in a network device, for example, a chip, a chip system, or another functional module that can invoke a program and execute the program.

FIG. 4 is a schematic interaction flowchart of a data compression and transmission method according to an embodiment of this application. With reference to FIG. 4, the method 200 includes some or all of the following processes:

S210: A first communication apparatus performs weighted encoding on first data based on a dictionary matrix, to obtain second data, where the second data expresses the first data based on k basis vectors in the dictionary matrix, k is a weighting parameter that is determined based on a first transmission resource and that is of the first data, and k is an integer greater than or equal to 1.

S220: The first communication apparatus sends the second data to a second communication apparatus on the first transmission resource; and correspondingly, the second communication apparatus receives the second data from the first communication apparatus on the first transmission resource.

S230: The second communication apparatus constructs the first data based on the second data and the dictionary matrix.

The first data may correspond to the sample vector set Y in the foregoing example, the dictionary matrix may correspond to the dictionary matrix D in the foregoing example, the second data may correspond to the weighting coefficient set X in the foregoing example, and the weighting coefficient set X includes location indication information and a weighting coefficient of a basis vector.

It should be understood that a larger quantity k of basis vectors that are in the second data and that express the first data indicates a larger data amount of the second data, that is, a larger transmission resource occupied by the second data. Therefore, in S210, the weighting parameter k of the first data is determined by using the first transmission resource, so that the second data obtained through weighted encoding can be transmitted on the first transmission resource, thereby achieving a balance between a transmission resource and compression performance.

The first communication apparatus may determine the weighting parameter k of the first data based on the first transmission resource; or the first communication apparatus may receive the weighting parameter that is of the first data and that is sent by the second communication apparatus.

Optionally, the second data includes location indication information and/or weighting coefficients of the k basis vectors. The location indication information indicates locations (for example, indexes) of the k basis vectors in the dictionary matrix, and the weighting coefficient is a weight of each of the k basis vectors used when the second data expresses the first data.

Optionally, the location indication information may include a tree structure, a bitmap, a location index, and the like. This is not limited in this application.

Optionally, the location indication information may indicate one basis vector combination from a plurality of preset basis vector combinations, and a quantity of basis vectors in each basis vector combination may be equal to k. In a possible implementation, the location indication information includes a first index, and the first index corresponds to one basis vector combination. The first communication apparatus and the second communication apparatus may prestore correspondences between a plurality of indexes and a plurality of basis vector combinations, and the plurality of indexes include the first index. For example, it is assumed that k is equal to 2. A $1^{st}$ basis vector and a $3^{rd}$ basis vector in the dictionary matrix belong to a $1^{st}$ basis vector combination, a $2^{nd}$ basis vector and a $4^{th}$ basis vector in the dictionary matrix belong to a $2^{nd}$ basis vector combination, the location indication information being 0 indicates the $1^{st}$ basis vector combination, and the location indication information being 1 indicates the $2^{nd}$ basis vector combination. Quantities of basis vectors included in all of the plurality of basis vector combinations may be the same or different. A correspondence between an index and a basis vector combination may be preset. For example, an index 0 corresponds to the $1^{st}$ basis vector combination, and an index 1 corresponds to the $2^{nd}$ basis vector combination.

The plurality of basis vector combinations may be preset in both the first communication apparatus and the second communication apparatus; or the plurality of basis vector combinations may be preset in the first communication apparatus, and the first communication apparatus configures the plurality of basis vector combinations for the second communication apparatus; or the plurality of basis vector combinations may be preset in the second communication apparatus, and the second communication apparatus configures the plurality of basis vector combinations for the first communication apparatus.

When the second data includes the location indication information of the k basis vectors, the weighting coefficients of the k basis vectors may be preset. For example, preset values of the weighting coefficients (for example, the weighting coefficients are 1) are preset in both the first communication apparatus and the second communication apparatus. Alternatively, the weighting coefficients of the k basis vectors may be preconfigured. For example, preset values of the weighting coefficients are preset in the second communication apparatus, and the second communication apparatus sends the preset values of the weighting coefficients to the first communication apparatus to configure the weighting coefficients. When the second data includes the weighting coefficients of the k basis vectors, the location indication information of the k basis vectors may be preset. For example, the location indication information of the k basis vectors (for example, the $1^{st}$ basis vector to a $k^{th}$ basis vector in the dictionary matrix) is preset in both the first communication apparatus and the second communication apparatus. Alternatively, the location indication information of the k basis vectors may be preconfigured. For example, the location indication information of the k basis vectors (for example, the $1^{st}$ basis vector to a $k^{th}$ basis vector in the dictionary matrix) is preset in the first communication apparatus, and the first communication apparatus sends the location indication information of the k basis vectors to the second communication apparatus to implement preconfiguration.

In a possible implementation, the dictionary matrix may be pre-agreed on by the first communication apparatus and the second communication apparatus, or sent by the first communication apparatus to the second communication apparatus in advance, or sent by the second communication apparatus to the first communication apparatus in advance, or defined in a protocol. This is not limited in this application.

In some embodiments, the first communication apparatus may send the dictionary matrix to the second communication apparatus on the first transmission resource.

After performing weighted encoding on the first data, the first communication apparatus obtains the location indication information and the weighting coefficients of the k basis vectors, and an updated dictionary matrix. Further, to improve a compression ratio of the first data, the first communication apparatus may perform quantization and/or entropy encoding on the second data, to obtain compressed data of the second data. In this case, S220 may be implemented as follows: The first communication apparatus sends the compressed data of the second data to the second communication apparatus on the first transmission resource. For example, the first communication apparatus may perform quantization (including scalar quantization or vector quantization) and entropy encoding on the weighting coefficient and the dictionary matrix, perform entropy encoding on the location indication information, and send, to the second communication apparatus, second information obtained through quantization and/or entropy encoding.

It should be noted in S230 that a process in which the second communication apparatus constructs the first data based on the second data and the dictionary matrix may also be referred to as a process of restoring the first data. Generally, there is a difference between the first data and data obtained by the second communication apparatus by constructing the first data. A smaller difference between the first data and the data obtained by constructing the first data indicates a smaller data loss in a compression and transmission process. Otherwise, a larger data loss is indicated.

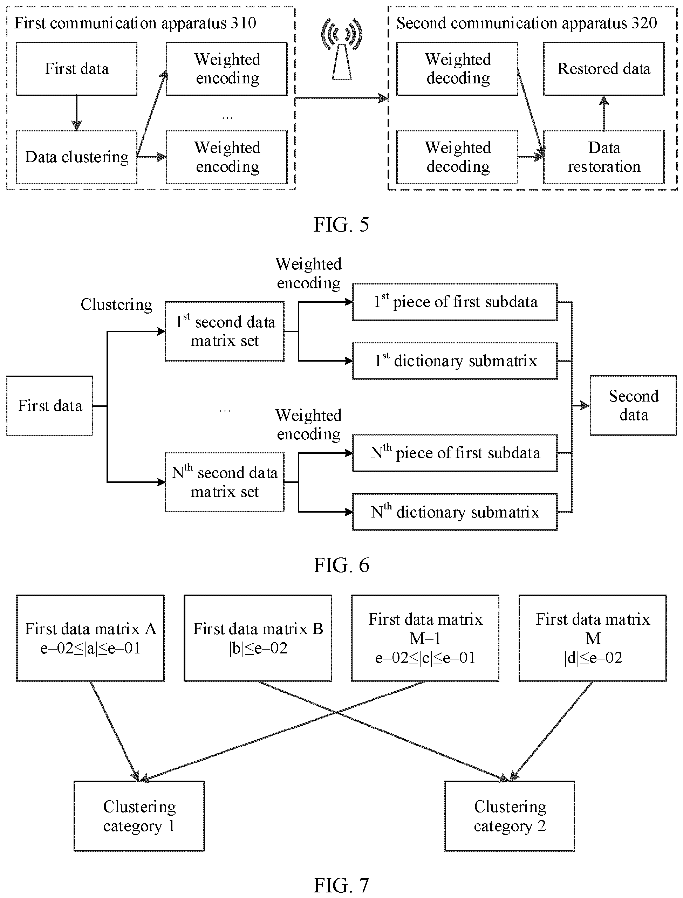

For some communication scenarios, for example, in a federated learning communication scenario, a data amount of to-be-transmitted data is large. To reduce overheads of a dictionary matrix and learn a sparse representation with better sparsity when the data amount of the to-be-transmitted data is relatively large, in a first possible implementation of this application, the first data is clustered, dictionary learning and sparse representation are performed on clustered data, and the clustered data is transmitted. Refer to FIG. 5, in a second possible implementation of this application, dictionary learning is performed on the first data, and compression and transmission are performed in a layered incremental manner. The following separately describes the two possible examples.

In a first possible implementation, compression and transmission are performed after clustering is performed.

Compression and transmission performed after clustering is performed may include a diagram of a data compression and transmission framework shown in FIG. 5. A first communication apparatus 310 may cluster the first data, separately perform weighted encoding on the clustered data, and send the clustered data to a second communication apparatus 320. The second communication apparatus separately performs weighted decoding on the received data, to implement data restoration and obtain the restored data.

Specifically, the compression and transmission performed after clustering is performed may include a diagram of a data compression and transmission framework shown in FIG. 6. As shown in FIG. 6, the first communication apparatus 310 may cluster the first data, for example, cluster M first datasets in the first data into N second datasets. Each second dataset includes at least one first dataset, and both M and N are integers greater than or equal to 1.

It should be noted that the first dataset may be a set of one or more pieces of data, and the first dataset may be represented in a form of a matrix. When the first dataset is represented in the form of a matrix, the first dataset may be referred to as a first data matrix. It should be understood that the first dataset is not a set of the first data but a component of the first data. The N second datasets are obtained by clustering the M first datasets. Similar to the first dataset, the second dataset may also be a set of one or more pieces of data. When the first dataset is represented in the form of a matrix, the second dataset may be a set of matrices, and may be referred to as a second data matrix set. The following uses only an example in which the first dataset is the first data matrix and the second dataset is the second data matrix set for description. However, this does not limit data forms of the first dataset and the second dataset.

In the federated learning scenario, the first data may include model parameter data, and the first data matrix may be a model parameter matrix.

In an example, the first communication apparatus 310 may cluster the M first data matrices into N second data matrix sets based on data types of the M first data matrices. For example, the first communication apparatus 310 may group model parameter data at a same network layer, model parameters at network layers of a same category, or model parameter data at adjacent network layers into a same second data matrix set as a same clustering category. A type of the network layer includes but is not limited to a convolutional layer, a fully connected layer, and the like.

The foregoing example may be a static clustering process. The first communication apparatus and the second communication apparatus may agree on one or more clustering manners. For example, parameter data at a same network layer is clustered, or parameter data at two adjacent network layers is clustered. When a plurality of clustering manners are agreed on in advance, the second communication apparatus may indicate one of the clustering manners to the first communication apparatus, so that the first communication apparatus performs clustering in the indicated clustering manner. Alternatively, the first communication apparatus may determine one clustering manner from the plurality of clustering manners to perform clustering, to indicate the used clustering manner to the second communication apparatus, so that the second communication apparatus performs data restoration.

In another example, the first communication apparatus 310 may cluster the M first data matrices into the N second data matrix sets based on boundary values of elements in the M first data matrices. For example, with reference to FIG. 7, an absolute value interval of boundary values corresponding to a clustering category 1 is [-∞, e-02], and an absolute value interval of boundary values corresponding to a clustering category 2 is [e-02, e-01], where e-01 is 10 to a power of minus 1, and e-02 is 10 to a power of minus 2. The first communication apparatus 310 may cluster the M first data matrices based on a relationship between absolute values of boundary values of elements in the M first data matrices and absolute value intervals of boundary values of clustering categories. Generally, absolute values of boundary values of elements in a same first data matrix are in a same order of magnitude or are close to each other in an order of magnitude. Refer to FIG. 7. Absolute values of boundary values of elements a in a first data matrix A are all greater than or equal to e-02 and less than or equal to e-01, absolute values of boundary values of elements b in a first data matrix B are all less than or equal to e-02, ..., absolute values of boundary values of elements c in a first data matrix M-1 are all greater than or equal to e-02 and less than or equal to e-01, and absolute values of boundary values of elements d in a first data matrix M are all less than or equal to e-02. In this case, the first data matrix A and the first data matrix M-1 (and another first data matrix that meets the absolute value interval of the boundary values of the clustering category 1) are clustered into a second data matrix set corresponding to the clustering category 1, and the first data matrix B and the first data matrix M (and another first data matrix that meets the absolute value interval of the boundary values of the clustering category 2) are clustered into a second data matrix set corresponding to the clustering category 2.

The foregoing example may be a dynamic clustering process. The first communication apparatus may send category indication information to the second communication apparatus, to indicate a clustering category of each of the M first data matrices. For example, a bit whose value is 0 may indicate the clustering category 1 of the first data matrix A, and a bit whose value is 1 may indicate the clustering category 2 of the first data matrix M. Certainly, an indication manner and a bit quantity of a clustering category are not limited in this application.

Refer to FIG. 6, the first communication apparatus 310 may perform weighted encoding on each of the N second data matrix sets, to obtain a first sub-dataset corresponding to the second data matrix set, and first sub-datasets respectively corresponding to the N second data matrix sets form the second data. The first communication apparatus 310 may perform weighted encoding on a part of the N second data matrix sets, and use another compression manner, for example, quantization and/or entropy encoding, on the other part of the second data matrix sets. The first communication apparatus 310 may determine, based on a clustering category of each second data matrix set, a compression manner (for example, weighting, quantization, or entropy encoding) used on the second data matrix set.

For example, a weighting parameter k of the second data may include a first weighting parameter k' corresponding to each of the N second data matrix sets, and first weighting parameters k' corresponding to any two of the N second data matrix sets may be the same or may be different. This is not limited in this application.

When weighted encoding is performed on each second data matrix set, dictionary learning may be performed based on the first weighting parameter k' corresponding to the second data matrix set, to control a quantity of basis vectors that express the second data matrix set, to implement flexible control on sparse expression of different second data matrix sets, thereby achieving a balance between compression performance and the transmission resource.

An example in which an $i^{th}$ second data matrix set in the N second data matrix sets is used. The first communication apparatus 310 may perform weighted encoding on the $i^{th}$ second data matrix set based on a first weighting parameter $k_i'$ of the $i^{th}$ second data matrix set, to obtain an $i^{th}$ first sub-dataset. The $i^{th}$ first sub-dataset may express the $i^{th}$ second data matrix set based on $k_i'$ basis vectors in the dictionary matrix, and the $i^{th}$ first sub-dataset may include location indication information and/or weighting coefficients of the $k_i'$ basis vectors.

The first weighting parameter $k_i'$ may be determined based on a data feature of the $i^{th}$ second data matrix set. Optionally, the data feature of the second data matrix set includes but is not limited to at least one of a data amount, data boundary values, or a mean variance of the second data matrix set. The data amount of the second data matrix set may be a sum of data amounts of all first data matrices in the second data matrix set. The data boundary values of the second data matrix set may include a maximum value and a minimum value of elements of all the first data matrices in the second data matrix set. The mean variance of the second data matrix set may be determined based on values of the elements of all the first data matrices in the second data matrix set.

The data feature of the second data matrix set may reflect a data amount proportion of the second data matrix set in the first data. Therefore, the first weighting parameter $k_i'$ is determined based on the data feature of the $i^{th}$ second data matrix set. When the $i^{th}$ second data matrix set occupies a large amount of data in the first data, weighted encoding may be performed on the $i^{th}$ second data matrix set based on a large first weighting parameter $k_i'$, so that the $i^{th}$ first sub-dataset expresses the $i^{th}$ second data matrix set based on a large quantity of basis vectors. When the $i^{th}$ second data matrix set occupies a small amount of data in the first data, weighted encoding may be performed on the $i^{th}$ second data matrix set based on a small first weighting parameter $k_i'$, so that the $i^{th}$ first sub-dataset expresses the $i^{th}$ second data matrix set based on a small quantity of basis vectors. Sparse expression of second data matrix sets of different data amounts is flexibly controlled, to implement the balance between the compression performance and the transmission resource.

When second data matrix sets of different clustering categories share a dictionary, the first communication apparatus 310 may perform weighted encoding on the $i^{th}$ second data matrix set based on the first weighting parameter $k_i'$ of the $i^{th}$ second data matrix set and the dictionary matrix D, to obtain the $i^{th}$ first sub-dataset. When all the second data matrix sets of different clustering categories do not share the dictionary, or some second data matrix sets do not share the dictionary, the dictionary matrix D may include N dictionary submatrices respectively corresponding to the N second data matrix sets. The first communication apparatus 310 may perform weighted encoding on the $i^{th}$ second data matrix set based on the first weighting parameter $k_i'$ of the $i^{th}$ second data matrix set and an $i^{th}$ dictionary submatrix $D_i$, to obtain the $i^{th}$ first sub-dataset.

It should be noted that one second data matrix set corresponds to one dictionary submatrix, a quantity of basis vectors in the dictionary submatrix is small, and a quantity of bits indicating location indication information of a basis vector in the dictionary submatrix is also small, thereby reducing a data size of the first sub-dataset and improving a compression rate. It should be understood that, when all the N second data matrix sets do not share the dictionary, the N dictionary submatrices are different. When a part of the N second data matrix sets do not share the dictionary, the N dictionary submatrices include at least two different dictionary submatrices. When the N second data matrix sets share the dictionary, the N dictionary submatrices may all be a same dictionary submatrix.

When the dictionary matrix D includes the N dictionary submatrices respectively corresponding to the N second data matrix sets, the first communication apparatus may send the N dictionary submatrices to the second communication apparatus. To reduce resource overheads for transmitting the dictionary submatrix, when a part of the N second data matrix sets share the dictionary, the first communication apparatus may send N' dictionary submatrices to the second communication apparatus. The N' dictionary submatrices are different dictionary submatrices in the N dictionary submatrices. In other words, a dictionary submatrix shared by two or more second data matrix sets are sent for only one time. In this case, the first communication apparatus may send dictionary indication information to the second communication apparatus. The dictionary indication information indicates the second data matrix sets corresponding to the dictionary submatrix (for example, indicates indexes of the corresponding second data matrix sets), and N' is less than N. Similarly, when all the N second data matrix sets share the dictionary, the first communication apparatus may send the shared dictionary submatrix to the second communication apparatus. In this case, the second communication apparatus determines that all the N second data matrix sets share the dictionary submatrix.

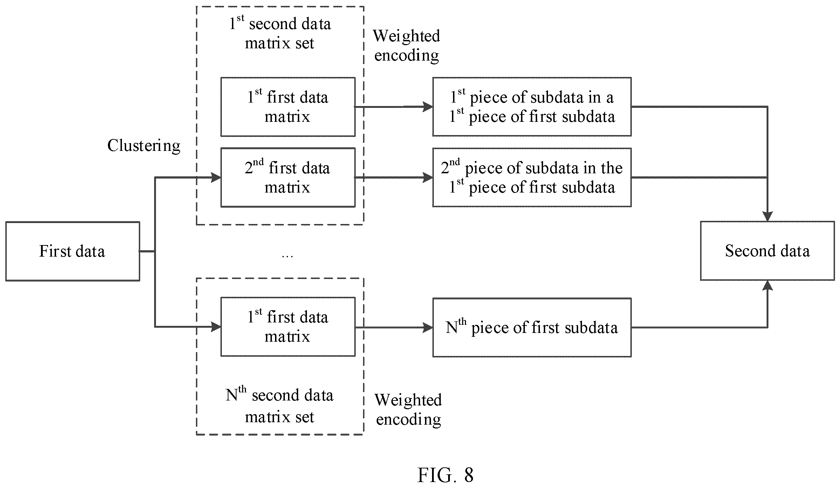

In some embodiments, to further improve the compression performance, each first data matrix in each second data matrix set may separately correspond to one second weighting parameter, to perform weighted encoding on the first data at a finer granularity. With reference to FIG. 8, for the $i^{th}$ second data matrix set, the first weighting parameter $k_i'$

corresponding to the $i^{th}$ second data matrix set includes second weighting parameters $k_i''$ corresponding to the first data matrices in the $i^{th}$ second data matrix set. The $i^{th}$ first sub-dataset includes a $j^{th}$ piece of subdata obtained by performing weighted encoding on a $j^{th}$ first data matrix in the $i^{th}$ second data matrix set based on the second weighting parameter $k_{ij}''$, and the $j^{th}$ piece of subdata in the $i^{th}$ first sub-dataset may express the $j^{th}$ first data matrix in the $i^{th}$ second data matrix set based on $k_{ij}''$ basis vectors in the $i^{th}$ dictionary submatrix corresponding to the $i^{th}$ second data matrix set. It should be understood that, when the N second data matrix sets share the dictionary matrix, the $k_{ij}''$ basis vectors are basis vectors in the shared dictionary submatrix.

Optionally, the second weighting parameter $k_{ij}''$ corresponding to the $j^{th}$ first data matrix in the $i^{th}$ second data matrix set may be determined based on a data feature of the $j^{th}$ first data matrix in the $i^{th}$ second data matrix set. Optionally, the data feature of the first data matrix includes but is not limited to at least one of a data amount, data boundary values, or a mean variance of the first data matrix. The data boundary values of the first data matrix may be a maximum value and a minimum value of all elements in the first data matrix, and the mean variance of the first data matrix may be determined based on values of all the elements in the first data matrix.

The data feature of the first data matrix may reflect a data amount proportion of the $j^{th}$ first data matrix in the $i^{th}$ second data matrix set. Therefore, the second weighting parameter $k_{ij}''$ is determined based on the data feature of the $j^{th}$ first data matrix. When the $j^{th}$ first data matrix occupies a large amount of data in the $i^{th}$ second data matrix set, weighted encoding may be performed on the $j^{th}$ first data matrix based on a large second weighting parameter $k_{ij}''$, so that the $j^{th}$ piece of subdata in the $i^{th}$ first sub-dataset expresses the $j^{th}$ first data matrix based on a large quantity of basis vectors. When an $i^{th}$ first data matrix occupies a small amount of data in the $i^{th}$ second data matrix set, weighted encoding may be performed on the $j^{th}$ first data matrix based on a small second weighting parameter $k_{ij}''$, so that the $j^{th}$ piece of subdata in the $i^{th}$ first sub-dataset expresses the $j^{th}$ first data matrix based on a small quantity of basis vectors. Sparse expression of first data matrices of different data amounts is flexibly controlled, to implement the balance between the compression performance and the transmission resource.

When the second data matrix sets of different clustering categories share the dictionary, the first communication apparatus 310 may perform weighted encoding on the $j^{th}$ first data matrix based on the second weighting parameter $k_{ij}''$ of the $j^{th}$ first data matrix in the $i^{th}$ second data matrix set and the dictionary matrix D, to obtain the $j^{th}$ piece of subdata in the $i^{th}$ first sub-dataset. When the second data matrix sets of different clustering categories do not share the dictionary, or some second data matrix sets do not share the dictionary, the dictionary matrix D may include N dictionary submatrices respectively corresponding to the N second data matrix sets. The first communication apparatus 310 may perform weighted encoding on the $j^{th}$ first data matrix based on the second weighting parameter $k_{ij}''$ of the $j^{th}$ first data matrix in the $i^{th}$ second data matrix set and the $i^{th}$ dictionary submatrix $D_i$, to obtain the $j^{th}$ piece of subdata in the $i^{th}$ first sub-dataset.

Refer to FIG. 5, the first communication apparatus 310 sends the second data to the second communication apparatus 320, and the second communication apparatus 320 may perform weighted decoding on the second data based on the first weighting parameter or the second weighting parameter, to restore the first data.

In an example, for the $i^{th}$ second data matrix set in the N second data matrix sets, when the second data matrix sets of different clustering categories share the dictionary, the second communication apparatus 320 may construct the $i^{th}$ second data matrix set based on the first weighting parameter $k_i'$ and the dictionary matrix D, to further combine the second data matrix sets to obtain the restored first data. When the second data matrix sets of different clustering categories do not share the dictionary, the dictionary matrix D may include the N dictionary submatrices respectively corresponding to the N second data matrix sets. The second communication apparatus 320 may construct the $i^{th}$ second data matrix set based on the first weighting parameter $k_i'$ and the $i^{th}$ dictionary submatrix $D_i$, to further combine the second data matrix sets to obtain the restored first data.

In another example, for the $j^{th}$ first data matrix in the $i^{th}$ second data matrix set, when the second data matrix sets of different clustering categories share the dictionary, the second communication apparatus 320 may construct the $j^{th}$ first data matrix based on the second weighting parameter $k_{ij}''$ and the dictionary matrix D, to further combine the first data matrices to obtain the restored second data matrix sets, and combine the second data matrix sets to obtain the restored first data. When the second data matrix sets of different clustering categories do not share the dictionary, the dictionary matrix D may include the N dictionary submatrices respectively corresponding to the N second data matrix sets, and the second communication apparatus 320 may construct the $j^{th}$ first data matrix based on the second weighting parameter $k_{ij}''$ and the $i^{th}$ dictionary submatrix $D_i$, to combine all the first data matrices to obtain the restored second data matrix sets, and combine the second data matrix sets to obtain the restored first data.

In a second possible implementation, layered incremental transmission is performed.

In the second possible implementation, the first communication apparatus performs weighted encoding on the first data to obtain the dictionary matrix D and third data. The third data expresses the first data based on K basis vectors in the dictionary matrix D, the K basis vectors include the k basis vectors, and K is an integer greater than or equal to k. In the layered incremental transmission process, the first communication apparatus may send the second data to the second communication apparatus in a first layered transmission process, and continue to transmit incremental data of the second data in a subsequent layered transmission process. It should be understood that the third data may include the second data and the incremental data of the second data. A process in which the first communication apparatus performs weighted encoding on the first data to obtain the dictionary matrix D and the third data may be an iterative learning process before S210.

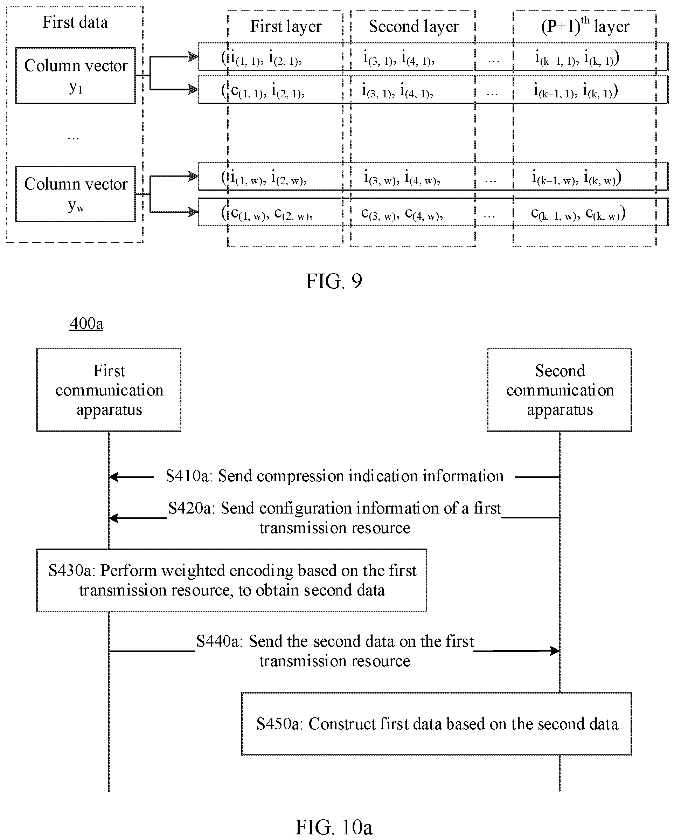

With reference to FIG. 9, for example, third data obtained after the first communication apparatus performs weighted encoding on the first data (for example, including column vectors $y_1$ to $y_w$) includes location indication information (for example, $i_{(1, 1)}$ to $i_{(K, W)}$) of the K basis vectors and weighting coefficients (for example, $c_{(1, 1)}$ to $c_{(K, W)}$) of the K basis vectors, where W is a quantity of column in the first data. When k is equal to 2, the second data transmitted by the first communication apparatus in the first layered transmission process includes the location indication information (for example, $i_{(1, 1)}$ to $i_{(2, W)}$) of the k basis vectors and the weighting coefficients (for example, $c_{(1, 1)}$ to $c_{(2, W)}$) of the k basis vectors. In an example shown in FIG. 9, only an example in which location indication information and weighting coefficients of two basis vectors are transmitted during layered transmission at each time is used. However, this is not limited.

It should be understood that, in comparison with the second data, the third data is closer to the first data, that is, the third data is more similar to the first data.

For example, the k basis vectors are first k basis vectors that are in the K basis vectors in the dictionary matrix D and that are in descending order of capabilities of expressing the first data.

For example, the first communication apparatus may send P pieces of incremental data of the second data to the second communication apparatus, where P is an integer greater than or equal to 1. For example, when P is equal to 1, the first communication apparatus transmits the incremental data in a second layered transmission process. For another example, when P is greater than 1, a 1st piece of incremental data is transmitted in the second layered transmission process, a 2nd piece of incremental data is transmitted in a third layered transmission process, ..., and a Pth piece of incremental data is transmitted in a (P+1)th layered transmission process.

$$\sum_{q=1}^{P} h_q$$

It should be noted that a sum of a quantity $\sum_{q=1}^{P} h_q$ of basis vectors in the P pieces of incremental data and k is less than or equal to K, where $h_q$ is a quantity of basis vectors that are in a qth piece of incremental data and that are used to incrementally express the first data. Quantities of basis vectors, used to express the first data, in the incremental data may be the same or may be different. This is not limited in this application.

In a static layering manner, any one of the P pieces of incremental data is subdata of the third data, and the qth piece of incremental data in the P pieces of incremental data may include location indication information and weighting coefficients of $h_q$ basis vectors in the third data. For example, with reference to FIG. 9, the 1st piece of incremental data transmitted by the first communication apparatus in the second layered transmission process includes location indication information (for example, $i_{(3, 1)}$ to $i_{(4, W)}$) of $h_1$ basis vectors and weighting coefficients (for example, $c_{(3, 1)}$ to $c_{(4, W)}$) of the $h_1$ basis vectors; ...; and a (K/2)th piece of incremental data transmitted by the first communication apparatus in a (K/2)th layered transmission process includes location indication information (for example, $i_{(K-1, 1)}$ to $i_{(K, W)}$) of $h_{K/2}$ basis vectors and weighting coefficients (for example, $C_{(K-1, 1)}$ to $c_{(K, W)}$) of the $h_{K/2}$ basis vectors.

In a dynamic layering manner, the qth piece of incremental data in the P pieces of incremental data is subdata of fourth data, and the fourth data may be determined based on the dictionary matrix D, the first data, and fourth data corresponding to a (q-1)th piece of incremental data. For example, the first communication apparatus may determine the fourth data based on the dictionary matrix D and a residual between the first data and data that is restored based on the fourth data corresponding to the (q-1)th piece of incremental data. A process in which the first communication apparatus determines, based on the dictionary matrix D, the first data, and the fourth data corresponding to the (q-1)th piece of incremental data, the fourth data corresponding to the qth piece of incremental data may be an iterative learning process before S210 or an iterative learning process after S220. When q=1, fourth data corresponding to the 1st piece of incremental data is determined based on the dictionary matrix D, the first data, and the second data. The qth piece of incremental data includes weighting coefficients of the k basis vectors in the fourth data, a weighting coefficient of a basis vector in at least one piece of incremental data in first q-1 pieces of incremental data in the P pieces of incremental data, and the location indication information and the weighting coefficients of $h_q$ basis vectors in the fourth data. For example, with reference to FIG. 9, the 1st piece of incremental data transmitted by the first communication apparatus in the second layered transmission process includes the weighting coefficients (for example, $c_{(1, 1)}$ to $c_{(2, W)}$) of the k basis vectors, and the location indication information (for example, $i_{(3, 1)}$ to $i_{(4, W)}$) and the weighting coefficients (for example, $c_{(3, 1)}$ to $c_{(4, W)}$) of the $h_1$ basis vectors; and a (K/2-1)th piece of incremental data transmitted by the first communication apparatus in the (K/2)th layered transmission process includes the weighting coefficients (for example, $c_{(1, 1)}$ to $c_{(2, W)}$) of the k basis vectors,

$$\sum_{q=1}^{K-2} h_q$$

weighting coefficients (for example, $c_{(3, 1)}$ to $C_{(K-2, W)}$) of $\sum_{q=1}^{K-2} h_q$ basis vectors in first K/2-2 pieces of incremental data in the P pieces of incremental data, and the location indication information (for example, $i_{(K-1, 1)}$ to $i_{(K, W)}$) and the weighting coefficients (for example, $c_{(K-1, 1)}$ to $c_{(K, W)}$) of the $h_{K/2}$ basis vectors.

$h_q$ is an integer less than K and greater than or equal to 1.

For example, the $h_q$ basis vectors are first $h_q$ basis vectors that are other than the k basis vectors in the K basis vectors and $\sum_{r=1}^{q-1} h_r$ basis vectors in the first q-1 pieces of incremental data and that are in descending order of capabilities of expressing the first data. Alternatively, the $h_q$ basis vectors are first $h_q$ basis vectors that are other than the k basis vectors in the K basis vectors and $\sum_{r=1}^{q-1} h_r$ basis vectors in the first q-1 pieces of incremental data and that are in descending order of capabilities of expressing a residual in the incremental transmission process. The residual in the incremental transmission process is a residual between the first data and fourth data corresponding to incremental data in a previous incremental transmission process of the incremental transmission process. $h_r$ is a quantity of basis vectors in one of the first q-1 pieces of incremental data.

In the foregoing dynamic layering process, when incremental transmission is performed at each layer, iterative learning is performed for one time, and a weighting coefficient of at least one of basis vectors selected in a previous layered transmission process is updated through iterative learning. In other words, the fourth data corresponding to the $q^{th}$ piece of incremental data includes location indication information and weighting coefficients of basis vectors in the second data and first q pieces of incremental data. In addition, the weighting coefficients of the basis vectors in the second data and the first q pieces of incremental data are updated after iterative learning in a $q^{th}$ incremental transmission process. In other words, weighting coefficients of basis vectors in the second data and the first q-1 pieces of incremental data in the fourth data corresponding to the $q^{th}$ piece of incremental data are different from weighting coefficients of basis vectors in the second data and the first q-1 pieces of incremental data in the fourth data corresponding to the $(q-1)^{th}$ piece of incremental data (including that weighting coefficients of all corresponding basis vectors are different, or weighting coefficients of some corresponding basis vectors are different). This optimizes the capability of expressing the first data, and improves the compression performance. In the foregoing static layering process, when incremental transmission is performed at each layer, location indication information and weighting coefficients of a part of basis vectors in the third data that are not transmitted are obtained through learning before the transmission, and iterative learning is not required for another time, thereby improving compression efficiency.

Based on the first possible implementation and the second possible implementation, layered incremental transmission may be further performed on at least one second data matrix set after clustering is performed. The following provides an example for description.

For example, the K basis vectors in the third data may include K' basis vectors separately corresponding to each second data matrix set. The $i^{th}$ second data matrix set in the N second data matrix sets is used as an example, and the $i^{th}$ second data matrix set may be expressed by using $K_i'$ basis vectors. In the foregoing embodiment, the $k_i'$ basis vectors that are included in the second data and that express the $i^{th}$ second data matrix set are a part of the $K_i'$ basis vectors, and the third data is obtained by performing weighted encoding on each second data matrix set in the first data. For the third data, refer to the description in the foregoing example. Details are not described herein again.

For example, the $k_i'$ basis vectors expressing the $i^{th}$ second data matrix set in the foregoing embodiment may be first $k_i'$ basis vectors that are in the $K_i'$ basis vectors and that are in descending order of capabilities of expressing the first data.

For the $q^{th}$ piece of incremental data in the P pieces of incremental data, the $q^{th}$ piece of incremental data may include the first subdata corresponding to each second data matrix set. The $i^{th}$ piece of first subdata corresponding to the $i^{th}$ second data matrix set is used as an example. The $i^{th}$ piece of first subdata expresses the $i^{th}$ second data matrix set based on $h_{(q,\ i)}$ basis vectors in the $i^{th}$ dictionary submatrix in the dictionary matrix. It should be noted that the $i^{th}$ piece of first subdata is only one type of incremental data in the second data matrix set, and the $i^{th}$ piece of first subdata expresses some information in the $i^{th}$ second data matrix set. Specifically, the $i^{th}$ piece of first subdata may express, based on the $h_{(q,i)}$ basis vectors in the $i^{th}$ dictionary submatrix in the dictionary matrix, a residual between the $i^{th}$ piece of first subdata and data obtained through restoration based on an $(i-1)^{th}$ piece of first subdata, where $h_{(q,i)}$ is an integer less than K and greater than or equal to 1. A sum of quantities $\sum_{i=1}^{N}\sum_{q=1}^{P} h_{(q,i)}$ and $\sum_{i=1}^{N} k_i'$ of basis vectors in the P pieces of incremental data is less than or equal to K.

In some embodiments, the first communication apparatus may perform foregoing layered incremental transmission on each of the N second data matrix sets. In some other embodiments, the first communication apparatus may perform foregoing layered incremental transmission on a part of the N second data matrix sets, and not perform layered incremental transmission on the other part of second data matrix sets. Alternatively, quantities for performing layered incremental transmission by the first communication apparatus on all of the N second data matrix sets are different, and a quantity for performing layered transmission on each second data matrix set may be related to the clustering category of the second data matrix set.

In the static layering manner, any one of the P pieces of incremental data is the subdata of the third data, and the $q^{th}$ piece of incremental data in the P pieces of incremental data may include location indication information and weighting coefficients of the $h_{(q, i)}$ basis vectors in the third data.

In the dynamic layering manner, the $q^{th}$ piece of incremental data in the P pieces of incremental data is the subdata of the fourth data, and the fourth data may be determined based on the $i^{th}$ dictionary submatrix $D_i$, the first data, and the fourth data corresponding to the $(q-1)^{th}$ piece of incremental data. When q is equal to 1, the fourth data corresponding to the $(q-1)^{th}$ piece of incremental data is the second data. In a possible implementation, the fourth data corresponding to the $1^{st}$ piece of incremental data may be determined based on the $i^{th}$ dictionary submatrix $D_i$ and the residual between the first data and the data that is restored based on the fourth data corresponding to the $(q-1)^{th}$ piece of incremental data. A process in which the first communication apparatus determines the fourth data based on the $i^{th}$ dictionary submatrix $D_i$, the first data, and fifth data may be an iterative learning process before S210 or an iterative learning process after S220. This is not limited in this application.

The $i^{th}$ piece of first subdata includes the weighting coefficients of the $k_i'$ basis vectors in the fourth data and/or the weighting coefficient of the basis vector in the at least one piece of incremental data in the first q-1 pieces of incremental data in the P pieces of incremental data, and the location indication information and the weighting coefficients of the $h_{(q, i)}$ basis vectors in the fourth data. Optionally, the weighting coefficient of the basis vector in the at least one piece of incremental data in the first q-1 pieces of incremental data included in the $i^{th}$ piece of first subdata may be weighting coefficients of $h_{(1, i)}$ basis vectors in the $1^{st}$ piece of incremental data in the P pieces of incremental data, or may be

$$\sum_{r=1}^{q-1} h_{(r,i)}$$

weighting coefficients of   basis vectors in the first q-1 pieces of incremental data in the P pieces of incremental data. It should be further understood that, if q is equal to 1, the $(q-1)^{th}$ piece of incremental data, namely, a $0^{th}$ piece of incremental data does not exist. In other words, the $i^{th}$ piece of first subdata does not include the weighting coefficient of the basis vector in the at least one piece of incremental data in the first q-1 pieces of incremental data. $h_{(r, i)}$ is a quantity of basis vectors in one piece of incremental data in the first q-1 pieces of incremental data corresponding to the $i^{th}$ piece of first subdata.

Based on any one of the foregoing embodiments, with reference to FIG. 10a to FIG. 10d, the following describes an example of how the first communication apparatus and the second communication apparatus implement data compression and transmission through signaling interaction in embodiments of this application.

FIG. 10a is a schematic interaction flowchart of a data compression and transmission method according to an embodiment of this application. The method 400a may include some or all of the following processes:

> S410a: A second communication apparatus sends compression indication information to a first communication apparatus, and correspondingly, the first communication apparatus receives the compression indication information.
> S420a: The second communication apparatus sends configuration information of a first transmission resource to the first communication apparatus, and correspondingly, the first communication apparatus receives the configuration information.
> S430a: The first communication apparatus performs weighted encoding based on the first transmission resource, to obtain second data.
> S440a: The first communication apparatus sends the second data to the second communication apparatus on the first transmission resource, and correspondingly, the second communication apparatus receives, on the first transmission resource, the second data sent by the first communication apparatus.
> S450a: The second communication apparatus constructs first data based on the second data.

The compression indication information may include compression hyperparameter information, the compression hyperparameter information indicates at least a target weighting parameter, the target weighting parameter is used to determine k, and the target weighting parameter is greater than or equal to k. For example, the target weighting parameter may be a maximum weighting parameter allowed by the first transmission resource, that is, the target weighting parameter is a maximum quantity of basis vectors used to express the first data.

The compression hyperparameter indication information may directly indicate the target weighting parameter, and the target weighting parameter may be determined by the network device based on the first transmission resource. In the foregoing implementation of compression and transmission after clustering is performed, the target weighting parameter may be used to determine a weighting parameter k' corresponding to each second matrix set.

**EP 4 586 567 A1**

Alternatively, the second communication apparatus may implicitly indicate the target weighting parameter by using the configuration information of the first transmission resource. In this case, the first communication apparatus may determine the target weighting parameter based on a resource size of the first transmission resource, to determine the weighting parameter k of the first data. In this case, the second communication apparatus may not send the compression indication information to the first communication apparatus to indicate the target weighting parameter. Certainly, a case in which the second communication apparatus sends the compression indication information to the first communication apparatus is not excluded, for example, the second communication apparatus may send the compression indication information to the first communication apparatus, to indicate other information listed below.

Optionally, S410a and S420a may be implemented as one sending process. In this case, the compression indication information may include the configuration information of the first transmission resource. For example, the configuration information of the first transmission resource may be included in the compression hyperparameter indication information in the compression indication information.

The compression hyperparameter indication information may further include information indicating a dimension of a basis vector and/or a quantity of basis vectors in the dictionary matrix D. For example, in FIG. 3, a dimension d of a basis vector and a quantity L of basis vectors are shown. For example, the dimension of a basis vector and/or the quantity of basis vectors in the dictionary matrix D may be determined based on storage space of the first communication apparatus. Generally, the basis vectors in the dictionary matrix D are directly proportional to the storage space of the first communication apparatus, and the quantity of basis vectors in the dictionary matrix is directly proportional to the storage space of the first communication apparatus. For example, the second communication apparatus may determine the dimension of a basis vector and the quantity of basis vectors in the dictionary matrix D based on a size of the storage space of the first communication apparatus, and indicate information about the dimension of a basis vector and/or the quantity of basis vectors in the dictionary matrix D to the first communication apparatus.

The first communication apparatus may send information about the storage space of the first communication apparatus (for example, including the size of the storage space) to the second communication apparatus. Optionally, the information about the storage space may be sent at a physical layer, or the information about the storage space may be carried in a buffer status report (buffer status report, BSR) and sent at a media access control (media access control, MAC) layer.

In addition to determining the information about the dimension of a basis vector and/or the quantity of basis vectors in the dictionary matrix D based on the storage space of the first communication apparatus, the second communication apparatus may further determine the information about the dimension of a basis vector and/or the quantity of basis vectors in the dictionary matrix D based on a bias of the second communication apparatus for performance, a compression rate, or the like; or may further determine the information about the dimension of a basis vector and/or the quantity of basis vectors in the dictionary matrix D based on the storage space, and a bias of the second communication apparatus for performance, a compression rate, or the like. Alternatively, the information about the dimension of a basis vector and/or the quantity of basis vectors in the dictionary matrix D may be a default value.

Optionally, the first communication apparatus may send a first transmission request to the second communication apparatus, and the second communication apparatus sends the configuration information of the first transmission resource to the first communication apparatus in response to the first transmission request. Optionally, the first transmission request may be carried in the BSR, to be sent at the MAC layer.

The information about the storage space of the first communication apparatus may be carried in the first transmission request for sending, or the information about the storage space of the first communication apparatus and the first transmission request may be separately sent. This is not limited in this application.

The compression indication information may further include information indicating a clustering manner of M first data matrices in the first data. For example, the information may indicate that the clustering manner of the M first data matrices is the foregoing static clustering or dynamic clustering. For another example, in the static clustering manner, the information may indicate to group first data matrices at a same network layer or first data matrices at adjacent network layers into a same second data matrix set as a same clustering category, or the like. For another example, in the dynamic clustering manner, the information may sequentially indicate clustering categories of all first data matrices by using M bits, or sequentially indicate clustering categories of all first data matrices by using $\left\lceil log_2^N \right\rceil$ bits. Certainly, the first communication apparatus and the second communication apparatus may agree on a fixed distance manner. In this case, the compression indication information may not include configuration information indicating the clustering manner of the M first data matrices in the first data.

The compression indication information may further include information indicating a compression manner of one or more of N second data matrix sets in the first data. For example, a layered incremental manner is used to compress a second data matrix set whose data amount is greater than a preset data amount and that is in the N second data matrix sets. For another example, N first weighting parameters k' are configured for each of the N second data matrix sets. For

25

another example, a compression manner of each second data matrix set is configured, and the compression manner includes but is not limited to quantization (including scalar quantization and/or vector quantization), weighted encoding, and the like.

The compression indication information may further include information indicating whether to perform entropy encoding on the second data.

In some communication scenarios, the first communication apparatus and the second communication apparatus may perform a plurality of rounds of interaction to complete a communication service. When the first communication apparatus and the second communication apparatus perform the plurality of rounds of interaction, in an $m^{th}$ round of interaction process, if the compression indication information does not change, compression indication information used in an $(m-1)^{th}$ round of interaction process may be shared. For example, if the first communication apparatus does not receive the compression indication information in the $m^{th}$ round of interaction process, the first communication apparatus uses the compression indication information received in the $(m-1)^{th}$ round of interaction process as the compression indication information in the $m^{th}$ round of interaction process.

S430a to S450a are described in the foregoing embodiment. For brevity, details are not described herein again.

In some embodiments, the first communication apparatus may send feedback information to the second communication apparatus, where the feedback information includes a weighting parameter $k_m$, and the weighting parameter $k_m$ is used to adjust a size of a transmission resource in a next round. For example, the first communication apparatus determines, based on the first data, the minimum weighting degree $k_m$ required to meet construction performance, and if $k_m$ is not equal to a weighting degree $k$ delivered by a base station, sends the feedback information of $k_m$ to the base station. When $k_m$ is less than $k$, the second communication apparatus reduces the size of the transmission resource (including the first transmission resource and/or a second transmission resource) configured in the next round, and when $k_m$ is greater than or equal to $k$, the second communication apparatus increases the size of the transmission resource (including the first transmission resource and/or the second transmission resource) configured in the next round.

Optionally, the feedback information may be carried in the BSR, to be sent at the MAC layer.

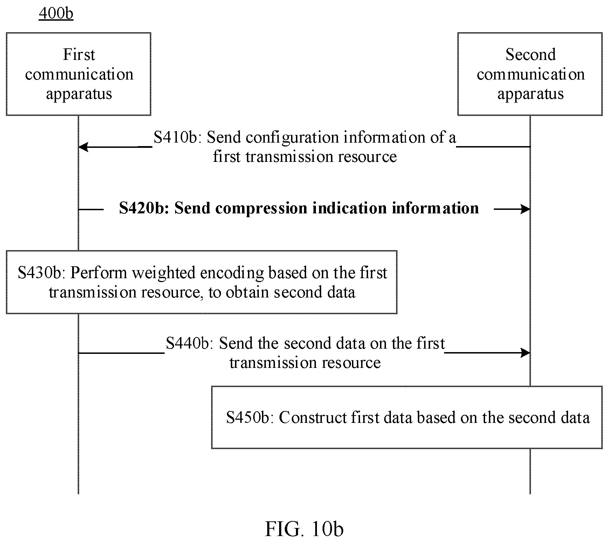

FIG. 10b is a schematic interaction flowchart of a data compression and transmission method according to an embodiment of this application. The method 400b may include some or all of the following processes:

S410b: A second communication apparatus sends configuration information of a first transmission resource to a first communication apparatus, and correspondingly, the first communication apparatus receives the configuration information that is sent by the second communication apparatus and that is of the first transmission resource.

S420b: The first communication apparatus sends compression indication information to the second communication apparatus, and correspondingly, the second communication apparatus receives the compression indication information sent by the first communication apparatus.

S430b: The first communication apparatus performs weighted encoding based on the first transmission resource, to obtain second data.

S440b: The first communication apparatus sends the second data to the second communication apparatus on the first transmission resource, and correspondingly, the second communication apparatus receives, on the first transmission resource, the second data sent by the first communication apparatus.

S450b: The second communication apparatus constructs first data based on the second data.

A difference between the embodiment shown in FIG. 10b and the embodiment shown in FIG. 10a lies in that the first communication apparatus sends the compression indication information to the second communication apparatus based on a data compression solution used by the first communication apparatus, so that the second communication apparatus constructs the first data based on an indication of the compression indication information.

Similar to the embodiment shown in FIG. 10a, the compression indication information may include compression hyperparameter information, the compression hyperparameter information indicates at least a target weighting parameter, and the compression indication information may be determined by the first communication apparatus based on the first transmission resource.

In addition, the compression indication information may further include at least one of the following:

configuration information indicating a clustering manner of M first data matrices in the first data;
configuration information indicating a compression manner of one or more of the N second data matrix sets in the first data; and
information indicating whether to perform entropy encoding on the second data.

For information included in the compression indication information, refer to the example in FIG. 10a. Details are not described herein again.

Optionally, the first communication apparatus may send the compression indication information on the first transmission resource, or use separate signaling for indication.

Optionally, the first communication apparatus may send the compression indication information before sending the second data, or send the compression indication information together with the second data. This is not limited in this application.

In some embodiments, the first communication apparatus may determine the compression manner of the one or more of the N second data matrix sets based on a data feature of the first data. The data feature of the first data may be, for example, a respective data feature of one or more second data matrix sets in the first data. The first communication apparatus determines a compression manner of a corresponding second dataset based on a data feature of each second data matrix set. For example, when the data feature of the second data matrix set indicates that a data amount proportion of the second data matrix set in the first data is large, a compression manner of weighted encoding is used. When the data feature of the second data matrix set indicates that the data amount proportion of the second data matrix set in the first data is small, a compression manner of quantization and/or entropy encoding is used.

As described above, the compression hyperparameter information may further include information indicating a dimension of a basis vector and/or a quantity of basis vectors in the dictionary matrix D. The first communication apparatus may determine the dimension of the basis vector and/or the quantity of basis vectors in the dictionary matrix D based on storage space of the first communication apparatus. For example, refer to Table 1. Values of d and L each are usually an $n^{th}$ power of 2. Then, a nearest (d, L) pair is selected based on locally provided storage space. If there are a plurality of (d, L) pairs that meet a condition, any one of the plurality of (d, L) pairs may be selected (or a (d, L) pair with a smaller value of d is selected for preferring performance, and a (d, L) pair with a larger value of d is selected for preferring compression efficiency).

Table 1

| d | 8 | | | | 16 | | | | 32 | | | | 64 | | | | 128 | | | | ... |
|---|----|-----|-----|-----|----|-----|-----|-----|----|-----|-----|-----|----|-----|-----|-----|----|-----|-----|-----|-----|
| L | 64 | 128 | 256 | ... | 64 | 128 | 256 | ... | 64 | 128 | 256 | ... | 64 | 128 | 256 | ... | 64 | 128 | 256 | ... | ... |

A larger data amount of the first data requires more efficient compression due to a limited transmission resource. In this case, a combination of larger d in Table 1 is preferentially selected based on the storage resource.

For example, that the first communication apparatus determines the target weighting parameter based on the first transmission resource may include:

The first communication apparatus may determine a compression ratio of the first data based on the first transmission resource and the data amount of the first data and according to the following formula:

$$\frac{A*\left(c*d\right)}{c*k_{max}*\left(log_2^L + w_2\right) + d*L*w_1}$$

c is a quantity of column vectors in first data Y, and A represents a quantity of original transmission bits of each parameter in the first data. For example, A may be 16, $w_1$ represents a quantization bit of a dictionary, $w_2$ represents a quantization bit of a coefficient.

$d*L*w_1$ represents dictionary overheads, which is small in comparison with $c*k_{max}*\left(log_2^L + w_2\right)$ in the denominator, and therefore, may be omitted. An amount of data obtained through compression is $c*k_{max}*\left(log_2^L + w_2\right)$. The amount of data obtained through compression is directly proportional to a target weighting parameter $k_{max}$. Therefore, a maximum weighting parameter (namely, the target weighting parameter) that meets the first transmission resource may be calculated.

If the first data is aggregated into second data matrix sets, for example, two second data matrix sets, under a plurality of clustering categories, the second data matrix sets do not share a dictionary matrix, and a transmission resource occupied by a sum of a data amount $c_1*k_1'*\left(log_2^{L_1} + w_2\right)$ of a 1st second data matrix set and a data amount $c_2*k_2'*\left(log_2^{L_2} + w_2\right)$ of a 2nd second data matrix set is less than or equal to the first transmission resource, an appropriate weighting parameter value $k_1$ may be preferentially selected for a second data matrix set with a larger quantity of column vectors, and a weighting parameter value (for example, $k_2$) is selected for a next second data matrix set based on a remaining resource. $c_1$ is a quantity of column vectors in the 1st second data matrix set, $k_i'$ is a weighting parameter of the 1st second data matrix set, and $L_1$ is a quantity of basis vectors in a 1st dictionary submatrix. $c_2$ is a quantity of column vectors in the 2nd second data matrix set, $k_2'$ is a weighting parameter of the 2nd second data matrix set, and $L_2$ is a quantity of basis vectors in a 2nd dictionary submatrix.

A process in which the second communication apparatus determines the target weighting parameter is similar to that of the first communication apparatus. Details are not described herein again.

In some embodiments, the first communication apparatus sends first compression parameter information to the second communication apparatus, where the first compression parameter information includes at least one of the following:

1. Information about a normalized parameter: When various types of data are separately normalized, for example, the second dataset is normalized, a normalized average value and a normalized standard value may be configured in a form like $[(mean_1, std_1), (mean_2, std_2)...]$. $mean_1$ is an average value of the 1st second dataset, $std_1$ is a standard deviation of the 1st second dataset, $mean_2$ is an average value of the 2nd second dataset, and $std_2$ is a standard deviation of the 2nd second dataset. The rest may be deduced by analogy. Details are not described again.

2. Boundary values of the dictionary matrix: For example, the dictionary submatrix corresponding to the second dataset may be configured in a form like $[(d\_max_1, d\_min_1), (d\_max_2, d\_min_2)...]$. $d\_max_1$ is a maximum value of an element in the 1st second dataset, $d\_min_1$ is a minimum value of an element in the 1st second dataset, $d\_max_2$ is a maximum value of an element in the 2nd second dataset, and $d\_min_2$ is a minimum value of an element in the 2nd second dataset. The rest may be deduced by analogy. Details are not described again.

3. Boundary values of a weighting coefficient of a basis vector in the second data: For example, boundary values of weighting coefficients of all basis vectors corresponding to the second dataset may be configured in a form like $[(c\_max_1, c\_min_1), (c\_max_2, c\_max_2)...]$. $c\_max_1$ is a maximum value in weighting coefficients of all basis vectors corresponding to the 1st second dataset, $d\_min_1$ is a minimum value in the weighting coefficients of all the basis vectors corresponding to the 1st second dataset, $c\_max_2$ is a maximum value in weighting coefficients of all basis vectors corresponding to the 2nd second dataset, and $c\_min_2$ is a minimum value in the weighting coefficients of all the basis vectors corresponding to the 2nd second dataset. The rest may be deduced by analogy. Details are not described again.

In some embodiments, the first communication apparatus may send category indication information to the second communication apparatus. The category indication information indicates a clustering category of each second data matrix set in the N second data matrix sets, for example, including a clustering category of an ith second data matrix set.

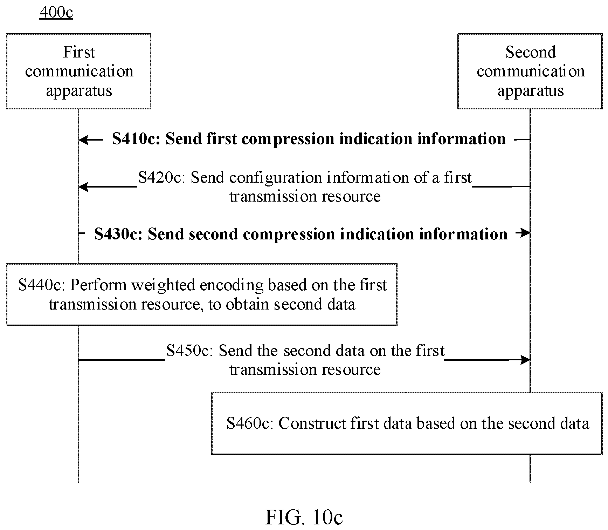

FIG. 10c is a schematic interaction flowchart of a data compression and transmission method according to an embodiment of this application. The method 400c may include some or all of the following processes:

S410c: A second communication apparatus sends first compression indication information to a first communication apparatus, and correspondingly, the first communication apparatus receives the first compression indication information sent by the second communication apparatus.

S420c: The second communication apparatus sends configuration information of a first transmission resource to the first communication apparatus, and correspondingly, the first communication apparatus receives the configuration information that is sent by the second communication apparatus and that is of the first transmission resource.

S430c: The first communication apparatus sends second compression indication information to the second communication apparatus, and correspondingly, the second communication apparatus receives the second compression indication information sent by the first communication apparatus.

S440c: The first communication apparatus performs weighted encoding based on the first transmission resource, to obtain second data.

S450c: The first communication apparatus sends the second data to the second communication apparatus on the first transmission resource, and correspondingly, the second communication apparatus receives, on the first transmission resource, the second data sent by the first communication apparatus.

S460c: The second communication apparatus constructs first data based on the second data.

In the embodiment shown in FIG. 10c, the first compression indication information and the second compression indication information may be included in the compression indication information in the embodiment shown in FIG. 10a or FIG. 10b. For example, a part of information in the compression indication information in the embodiment shown in FIG. 10a or FIG. 10b is configured by the second communication apparatus for the first communication apparatus, and the other part of information in the compression indication information is reported by the first communication apparatus to the second communication apparatus, to complete synchronization of the compression indication information between the first communication apparatus and the second communication apparatus.

For example, the first compression indication information may indicate a static parameter, for example, configure a static clustering manner, or for another example, configure a static layering manner. The second compression indication information may indicate a dynamic parameter, for example, indicate a dynamic clustering manner, or indicate a dynamic layering manner. For example, when the second compression indication information indicates the dynamic parameter, the second compression indication information may further include compression hyperparameter information.

S420c and S440c to S460c are similar to those in the foregoing embodiment. Details are not described herein again.

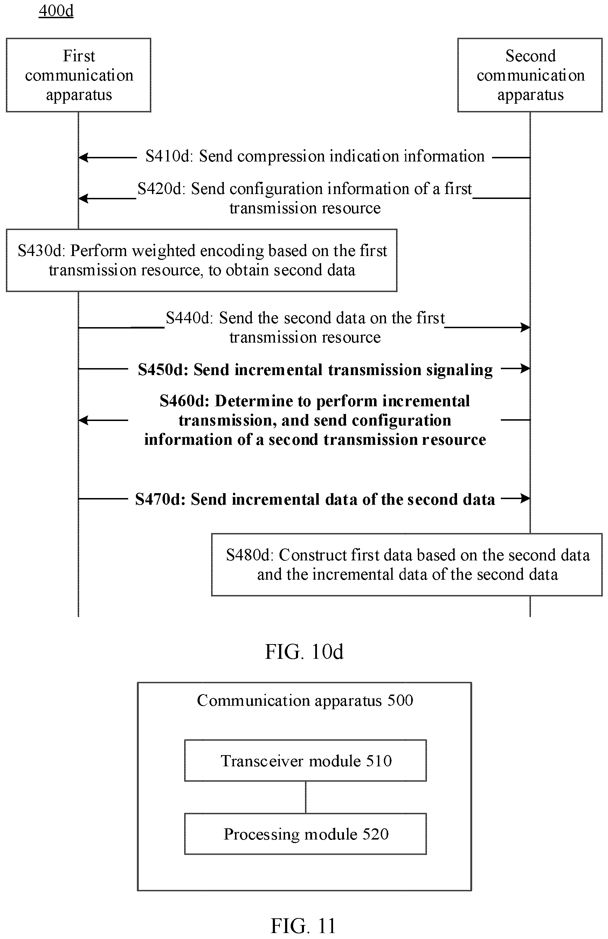

Based on FIG. 10a to FIG. 10c, when incremental data is transmitted between the first communication apparatus and the second communication apparatus, some or all processes in a method 400d shown in FIG. 10d may be further included. FIG. 10d is described by using an example in which incremental transmission is implemented based on FIG. 10a. FIG. 10d is a schematic interaction flowchart of a data compression and transmission method according to an embodiment of this application. The method 400d may include the following steps:

S410d: A second communication apparatus sends compression indication information to a first communication apparatus, and correspondingly, the first communication apparatus receives the compression indication information sent by the second communication apparatus.

S420d: The second communication apparatus sends configuration information of a first transmission resource to the first communication apparatus, and correspondingly, the first communication apparatus receives the configuration information that is sent by the second communication apparatus and that is of the first transmission resource.

S430d: The first communication apparatus performs weighted encoding based on the first transmission resource, to obtain second data.

S440d: The first communication apparatus sends the second data to the second communication apparatus on the first transmission resource, and correspondingly, the second communication apparatus receives, on the first transmission resource, the second data sent by the first communication apparatus.

S450d: The first communication apparatus sends incremental transmission signaling to the second communication apparatus, and correspondingly, the second communication apparatus receives the incremental transmission signaling sent by the first communication apparatus.

S460d: The second communication apparatus determines that incremental transmission is required, and sends configuration information of a second transmission resource to the first communication apparatus; and correspondingly, the first communication apparatus receives the configuration information that is sent by the second communication apparatus and that is of the second transmission resource.

S470d: The first communication apparatus sends incremental data of the second data to the second communication apparatus on the second transmission resource, and correspondingly, the second communication apparatus receives, on the second transmission resource, the incremental data of the second data sent by the first communication apparatus.

S480d: The second communication apparatus constructs first data based on the second data and the incremental data of the second data.

S410d to S440d have been described in the foregoing embodiment related to FIG. 10a, and S410d to S440d may alternatively be replaced with S410b and S440b in the example shown in FIG. 10b or S410c to S450c in the example shown in FIG. 10c. A difference thereof lies in that the second communication apparatus cannot construct the first data based on the second data. In other words, there is a large error between the first data obtained by the second communication apparatus by constructing the first data based on the second data and the original first data. In S420d, the second communication apparatus may determine, based on a first transmission request of the first communication apparatus, a transmission resource required by full data (including the second data and the incremental data of the second data) that needs to be transmitted by the first communication apparatus. When resources are insufficient (or to avoid reducing impact on a communication service), the first transmission resource configured by the second communication apparatus for the first communication apparatus is used to transmit only the second data.

In some embodiments, the second communication apparatus may send the configuration information of the second transmission resource together with the configuration information of the first transmission resource. In other words, the second communication apparatus may send configuration information of transmission resources to the first communication apparatus. The transmission resources include the first transmission resource and the second transmission resource, and the second transmission resource is used to transmit the incremental data of the second data. In some other embodiments, the second communication apparatus may separately send the configuration information of the second transmission resource. This is not limited in this application, and a sending occasion of the configuration information of the second transmission resource is not limited. For example, the second communication apparatus may send the configuration information of the second transmission resource in response to an incremental transmission request sent by the first communication apparatus, or the second communication apparatus may send the configuration information of the second transmission resource to the first communication apparatus when determining that construction performance of constructing the first data is poor, and the like.

In S450d, the first communication apparatus may send the incremental transmission signaling to the second communication apparatus when the incremental data of the second data needs to be sent, to request incremental transmission.

In S450d, when the first communication apparatus does not need to send the incremental data of the second data (for example, compression and transmission of the first data have been completed), the first communication apparatus may not send the incremental transmission signaling, and the second communication apparatus determines, when not receiving the incremental transmission signaling, to complete compression and transmission of the first data. Alternatively, the first communication apparatus may send the incremental transmission signaling to the second communication apparatus, to indicate the second communication apparatus to end compression and transmission of the first data.

Optionally, the incremental transmission signaling may include a data size of the incremental data (or a size of a transmission resource required by the incremental data). The data size of the incremental data (or the size of the transmission resource required by the incremental data) may be obtained through calculation in a static or dynamic manner.

Optionally, the incremental transmission signaling may be carried in a BSR for sending.

After receiving the incremental transmission signaling, the second communication apparatus may send the configuration information of the second transmission resource to the first communication apparatus. Alternatively, after receiving the incremental transmission signaling, the second communication apparatus may determine whether incremental transmission is required, and send the incremental data of the second data to the second communication apparatus when incremental transmission is required; or send transmission termination signaling to the first communication apparatus or perform no operation when determining that incremental transmission is not required.

For example, the second communication apparatus may analyze, based on the constructed first data, whether the construction performance meets a service requirement. When the construction performance meets the service requirement, incremental transmission is not required. When the construction performance does not meet the service requirement, incremental transmission is required.

It should be understood that, when a data amount of the incremental data of the second data is still large, the incremental data may be divided into a plurality of pieces, for example, the P pieces of incremental data in the foregoing embodiment. In some embodiments, the configuration information of the second transmission resource may indicate transmission resources of the P pieces of incremental data. In some other embodiments, the configuration information of the second transmission resource may include P pieces of configuration sub-information, each piece of configuration sub-information is used to configure a transmission resource of one piece of incremental data, and the P pieces of configuration sub-information may be independently sent. For example, before the first communication apparatus sends one piece of incremental data each time, the second communication apparatus sends corresponding configuration sub-information. For example, the first communication apparatus may receive a 1st piece of configuration sub-information sent by the second communication apparatus, and determine, based on the 1st piece of configuration sub-information, a resource used for incremental transmission. When the incremental transmission resource configured based on the 1st piece of configuration sub-information is small, the first communication apparatus transmits a part of the incremental data, for example, transmits a 1st piece of incremental data in the P pieces of incremental data. Further, the second communication apparatus determines, based on a 2nd piece of configuration sub-information, a resource used for incremental transmission for another time, and the like. The rest may be deduced by analogy until all the incremental data is transmitted.

The configuration information of the second transmission resource is similar to the configuration information of the first transmission resource. For example, both the configuration information of the second transmission resource and the configuration information of the first transmission resource may be used to determine a weighting parameter. In other words, the first communication apparatus may determine a weighting parameter of the incremental data of the second data based on the configuration information of the second transmission resource. For brevity, details are not described herein again.

Optionally, before S460d, the first communication apparatus may send a second transmission request to the second communication apparatus, where the second transmission request is used to request to send the incremental data of the second data. When the data amount of the incremental data of the second data is still large, the incremental data may be divided into the plurality of pieces of incremental data, for example, the P pieces of incremental data in the foregoing embodiment. Before sending each piece of incremental data, the first communication apparatus may send a second transmission request of the piece of incremental data to the second communication apparatus.

In some embodiments, the first communication apparatus sends second compression parameter information to the second communication apparatus, where the second compression parameter information includes at least one of the following:

boundary values of a weighting coefficient of a basis vector in the incremental data of the second data.

It should be noted that the second compression parameter information and first compression parameter information may be independent information, or the second compression parameter information and first compression parameter information may be transmitted together as components of compression parameter information. This is not limited in this application.

It should be understood that the configuration information of the first transmission resource and the configuration information of the second transmission resource in FIG. 10a to FIG. 10d may be independent information, or the configuration information of the first transmission resource and the configuration information of the second transmission resource may be transmitted together as components of configuration information of the transmission resources. This is not limited in this application.

Therefore, in embodiments of this application, weighted encoding is performed on the to-be-transmitted first data, to express the to-be-transmitted first data based on the k basis vectors, so that the physical layer data is compressed while the low data loss is ensured. Further, the weighting parameter k used to perform weighted encoding on the first data is determined based on the first transmission resource, so that the balance between the transmission resource and compression performance is implemented, to avoid the case in which when the transmission resources are sufficient, the large amount of transmitted data is lost due to the excessive compression, or the case in which when the transmission resources are insufficient, the compressed data cannot be transmitted due to the large amount of compressed data. Effective and reliable data compression is performed on the to-be-transmitted data.

To implement the functions in the methods provided in embodiments of this application, the first communication apparatus and the second communication apparatus each may include a hardware structure and/or a software module. The foregoing functions are implemented in a form of a hardware structure, a software module, or a hardware structure and a software module. Whether a function in the foregoing functions is performed by using the hardware structure, the software module, or a combination of the hardware structure and the software module depends on particular applications and design constraints of the technical solutions.

As shown in FIG. 11, an embodiment of this application provides a communication apparatus 500. The communication apparatus 500 may be a terminal or a network device, an apparatus in a terminal or a network device, or an apparatus that can be used together with a terminal device and a network device. In a possible implementation, the communication apparatus 500 may include modules or units that one-to-one correspond to the methods/operations/steps/actions performed by the first communication apparatus or the second communication apparatus in the foregoing method embodiments. The units may be implemented by a hardware circuit, software, or a combination of a hardware circuit and software. In a possible implementation, the communication apparatus 500 may include a transceiver module 510 and a processing module 520. The processing module 520 may be configured to invoke the transceiver module 510 to perform a receiving and/or sending function.

Optionally, the communication apparatus 500 may correspond to the first communication apparatus in the foregoing method embodiments.

It should be understood that the communication apparatus 500 may include modules that perform the method on the first communication apparatus side in the methods in embodiments of this application. In addition, the modules in the communication apparatus 500 and the foregoing other operations and/or functions are separately used to implement corresponding procedures of the methods.

When the communication apparatus 500 is configured to perform the method on the first communication apparatus side, the processing module 520 may be configured to perform weighted encoding on first data based on a dictionary matrix, to obtain second data. The second data expresses the first data based on k basis vectors in the dictionary matrix, k is a weighting parameter that is determined based on a first transmission resource and that is of the first data, and k is an integer greater than or equal to 1. The transceiver module 510 may be configured to send the second data to a second communication apparatus on the first transmission resource.

It should be understood that specific processes performed by the modules are described in detail in the foregoing method embodiments. For brevity, details are not described herein again.

Optionally, the communication apparatus 500 may correspond to the second communication apparatus in the foregoing method embodiments.

It should be understood that the communication apparatus 500 may include modules that perform the method on the second communication apparatus side in the methods in embodiments of this application. In addition, the modules in the communication apparatus 500 and the foregoing other operations and/or functions are separately used to implement corresponding procedures of the methods.

When the communication apparatus 500 is configured to perform the method on the second communication apparatus side, the transceiver module 510 may be configured to receive, on a first transmission resource, second data from a first communication apparatus. The second data expresses first data based on k basis vectors in a dictionary matrix, k is a weighting parameter that is determined based on the first transmission resource and that is of the first data, and k is an integer greater than or equal to 1. The processing module 520 may be configured to construct the first data based on the second data and the dictionary matrix.

It should be understood that specific processes performed by the modules are described in detail in the foregoing method embodiments. For brevity, details are not described herein again.

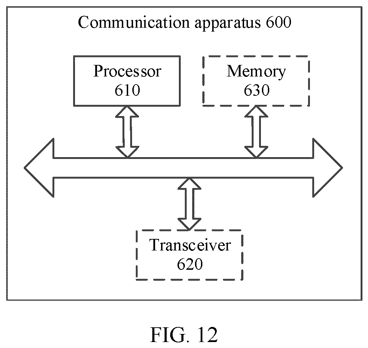

The transceiver module 510 in the communication apparatus 500 may be implemented by using a transceiver, for example, may correspond to a transceiver 620 in a communication apparatus 600 shown in FIG. 12. The processing module 520 in the communication apparatus 500 may be implemented by using at least one processor, for example, may correspond to a processor 610 in the communication apparatus 600 shown in FIG. 12.

When the communication apparatus 500 is a chip or a chip system configured in a communication device (like a terminal device or a network device), the transceiver unit 510 in the communication apparatus 500 may be implemented by using an input/output interface, a circuit, or the like. The processing unit 520 in the communication apparatus 500 may be implemented by using a processor, a microprocessor, an integrated circuit, or the like integrated in the chip or the chip system.

FIG. 12 is another block diagram of a communication apparatus according to an embodiment of this application. As shown in FIG. 12, the communication apparatus 600 may include the processor 610. The processor 610 may be configured to perform the method performed by the first communication apparatus or the second communication apparatus in the foregoing method embodiments.

In some possible implementations, the communication apparatus 600 may include the transceiver 620. The transceiver 620 and the processor 610 may communicate with each other through an internal connection path. The processor 610 may control the transceiver 620 to send a signal and/or receive a signal.

In some possible implementations, the communication apparatus 600 may include a memory 630. The memory 630 and the processor 610 may communicate with each other through an internal connection path. The memory 630 and the processor 610 may be integrated together, or disposed separately. The memory 630 may alternatively be a memory outside the apparatus. The memory 630 is configured to store instructions, and the processor 610 is configured to execute the instructions stored in the memory 630, to perform the method in the foregoing method embodiments.

It should be understood that the communication apparatus 600 may correspond to the first communication apparatus or the second communication apparatus in the foregoing method embodiments, and may be configured to perform the steps and/or procedures performed by the first communication apparatus or the second communication apparatus in the foregoing method embodiments. Optionally, the memory 630 may include a read-only memory and a random access memory, and provide the instructions and data for the processor. A part of the memory may further include a non-volatile random access memory. The memory 630 may be a separate component, or may be integrated into the processor 610. The processor 610 may be configured to execute the instructions stored in the memory 630, and when the processor 610 executes the instructions stored in the memory, the processor 610 is configured to perform the steps and/or procedures in the foregoing method embodiments corresponding to the first communication apparatus or the second communication apparatus.

Optionally, the communication apparatus 600 is the first communication apparatus in the foregoing embodiments.

Optionally, the communication apparatus 600 is the second communication apparatus in the foregoing embodiments.

The transceiver 620 may include a transmitter and a receiver. The transceiver 620 may further include one or more antennas. The processor 610, the memory 630, and the transceiver 620 may be components integrated on different chips. For example, the processor 610 and the memory 630 may be integrated into a baseband chip, and the transceiver 620 may be integrated into a radio frequency chip. Alternatively, the processor 610, the memory 630, and the transceiver 620 may be components integrated on a same chip. This is not limited in this application.

The transceiver 620 may alternatively be a communication interface, for example, an input/output interface or a circuit. The transceiver 620, the processor 610, and the memory 630 may be integrated into a same chip, for example, integrated into the baseband chip.

This application further provides a processing apparatus, including at least one processor. The at least one processor is configured to run a computer program or a logic circuit to enable the processing apparatus to perform the method performed by the first communication apparatus or the second communication apparatus in the foregoing method embodiments. The processing apparatus may further include a memory, and the memory is configured to store the computer program.

An embodiment of this application further provides a processing apparatus, including a processor and an input/output interface. The input/output interface is coupled to the processor. The input/output interface is configured to input and/or output information. The information includes at least one of instructions and data. The processor is configured to execute a computer program to enable the processing apparatus to perform the method performed by the first communication apparatus or the second communication apparatus in the foregoing method embodiments.

An embodiment of this application further provides a processing apparatus, including a processor and a memory.

The memory is configured to store a computer program, and the processor is configured to invoke the computer program from the memory and run the computer program to enable the processing apparatus to perform the method performed by the first communication apparatus or the second communication apparatus in the foregoing method embodiments.

It should be understood that, the processing apparatus may be one or more chips. For example, the processing apparatus may be a field programmable gate array (field programmable gate array, FPGA), an application-specific integrated circuit (application-specific integrated circuit, ASIC), a system on chip (system on chip, SoC), a central processing unit (central processing unit, CPU), a network processor (network processor, NP), a digital signal processor (digital signal processor, DSP), a micro controller unit (micro controller unit, MCU), or a programmable logic device (programmable logic device, PLD) or another integrated chip.

In an implementation process, the steps in the foregoing methods may be completed by using a hardware integrated logic circuit in the processor, or by using instructions in a form of software. The steps of the methods disclosed with reference to embodiments of this application may be directly performed by a hardware processor, or may be performed by using a combination of hardware and software modules in the processor. The software module may be located in a mature storage medium in the art, for example, a random access memory, a flash memory, a read-only memory, a programmable read-only memory, an electrically erasable programmable memory, a register, or the like. The storage medium is located in the memory, and the processor reads the information in the memory and completes the steps in the foregoing methods in combination with the hardware of the processor. To avoid repetition, details are not described herein again.

It should be noted that the processor in embodiments of this application may be an integrated circuit chip, and has a signal processing capability. In an implementation process, the steps in the foregoing method embodiments may be completed by using a hardware integrated logic circuit in the processor or instructions in a form of software. The foregoing processor may be a general-purpose processor, a digital signal processor (DSP), an application-specific integrated circuit (ASIC), a field programmable gate array (FPGA) or another programmable logic device, a discrete gate or a transistor logic device, or a discrete hardware component. The processor may implement or perform the methods, the steps, and the logical block diagrams that are disclosed in embodiments of this application. The general-purpose processor may be a microprocessor, or the processor may be any conventional processor or the like. The steps of the methods disclosed with reference to embodiments of this application may be directly performed by a hardware decoding processor, or may be performed by using a combination of hardware and software modules in the decoding processor. The software module may be located in a mature storage medium in the art, for example, a random access memory, a flash memory, a read-only memory, a programmable read-only memory, an electrically erasable programmable memory, a register, or the like. The storage medium is located in the memory, and the processor reads the information in the memory and completes the steps in the foregoing methods in combination with the hardware of the processor.

It may be understood that the memory in embodiments of this application may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM) that is used as an external cache. By way of example but not limitation, a plurality of forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus random access memory (direct rambus RAM, DR RAM). It should be noted that the memories in the systems and methods described in this specification include but are not limited to these memories and any memory of another suitable type.

According to the method provided in embodiments of this application, this application further provides a computer program product. The computer program product includes a computer program or a group of instructions. When the computer program or the group of instructions are run on a computer, the computer is enabled to perform the method performed by the first communication apparatus or the second communication apparatus in the foregoing method embodiments.

According to the method provided in embodiments of this application, this application further provides a computer-readable storage medium. The computer-readable storage medium stores a program. When the program is run on a computer, the computer is enabled to perform the method performed by the first communication apparatus or the second communication apparatus in the foregoing method embodiments.

According to the method provided in embodiments of this application, this application further provides a communication system. The communication system may include the foregoing first communication apparatus or second communication apparatus.

Terms such as "component", "module", "unit", and "system" used in this specification indicate computer-related entities, hardware, firmware, combinations of hardware and software, software, or software being executed. For example, a component may be, but is not limited to, a process that runs on a processor, a processor, an object, an executable file, an execution thread, a program, and/or a computer. As illustrated by using figures, both a computing device and an application that runs on the computing device may be components. One or more components may reside within a process and/or a thread of execution, and a component may be located on one computer and/or distributed between two or more computers. In addition, the components may be executed from various computer-readable media that store various data structures. For example, the components may communicate by using a local and/or remote process and based on, for example, a signal having one or more data packets (for example, data from two components interacting with another component in a local system, a distributed system, and/or across a network like the Internet interacting with other systems by using the signal).

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed systems, apparatuses, and methods may be implemented in other manners. For example, the described apparatus embodiments are merely examples. For example, division into the units is merely logical function division. There may be another division manner during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on an actual requirement to achieve the objectives of the solutions of embodiments.

In addition, functional units in embodiments of this application may be integrated into one processing unit, or each of the units may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, or some of the technical solutions may be embodied in a form of a software product. The computer software product is stored in a storage medium, and includes several instructions for enabling a computer device (which may be a personal computer, a server, a network device, or the like) to perform all or some steps of the methods in embodiments of this application. The foregoing storage medium includes any medium that can store program code, for example, a USB flash drive, a removable hard disk, a ROM, a RAM, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A data compression and transmission method, comprising:

    performing, by a first communication apparatus, weighted encoding on first data based on a dictionary matrix, to obtain second data, wherein the second data expresses the first data based on k basis vectors in the dictionary matrix, k is a weighting parameter that is determined based on a first transmission resource and that is of the first data, and k is an integer greater than or equal to 1; and
    sending, by the first communication apparatus, the second data to a second communication apparatus on the first transmission resource.

2. The method according to claim 1, wherein the first data comprises M first datasets, the M first datasets are clustered into N second datasets, the second dataset comprises at least one first dataset, and M and N are both integers greater than or equal to 1.

3. The method according to claim 2, wherein the weighting parameter k of the first data comprises a first weighting parameter $k_i'$ corresponding to an $i^{th}$ second dataset in the N second datasets; and
the second data comprises an $i^{th}$ first sub-dataset obtained by performing weighted encoding on the $i^{th}$ second dataset based on the first weighting parameter $k_i'$, and the $i^{th}$ first sub-dataset expresses the $i^{th}$ second dataset based on $k_i'$ basis vectors in the dictionary matrix.

4. The method according to claim 3, wherein the dictionary matrix comprises N dictionary submatrices respectively corresponding to the N second datasets, and the N dictionary submatrices comprise at least two different dictionary submatrices.

5. The method according to claim 3, wherein the first weighting parameter $k_i'$ corresponding to the $i^{th}$ second dataset comprises a second weighting parameter $k_i''$ corresponding to each first dataset in the $i^{th}$ second dataset; and

the $i^{th}$ first sub-dataset comprises a $j^{th}$ piece of subdata obtained by performing weighted encoding on a $j^{th}$ first dataset in the $i^{th}$ second dataset based on the second weighting parameter $k_{ij}''$, and the $j^{th}$ piece of subdata expresses the $j^{th}$ first dataset in the $i^{th}$ second dataset based on $k_{ij}''$ basis vectors in an $i^{th}$ dictionary submatrix corresponding to the $i^{th}$ second dataset, wherein
the second weighting parameter $k_{ij}''$ is determined based on a data feature of the $j^{th}$ first dataset in the $i^{th}$ second dataset.

6. The method according to any one of claims 3 to 5, wherein K basis vectors in third data comprise $K_i'$ basis vectors corresponding to the $i^{th}$ second dataset, the third data is obtained by performing weighted encoding on each second dataset in the first data, the K basis vectors comprise the k basis vectors, and the $k_i'$ basis vectors in the $i^{th}$ second dataset are first $k_i'$ basis vectors that are in the $K_i'$ basis vectors and that are in descending order of capabilities of expressing the first data.

7. The method according to claim 1, wherein the method further comprises:
performing, by the first communication apparatus, weighted encoding on the first data to obtain the dictionary matrix and third data, wherein the third data expresses the first data based on K basis vectors in the dictionary matrix, the K basis vectors comprise the k basis vectors, and K is an integer greater than or equal to k.

8. The method according to claim 7, wherein the k basis vectors are first k basis vectors that are in the K basis vectors in the dictionary matrix and that are in descending order of capabilities of expressing the first data.

9. The method according to claim 7 or 8, wherein the method further comprises:

sending, by the first communication apparatus, P pieces of incremental data of the second data to the second communication apparatus, wherein P is an integer greater than or equal to 1; and
a $q^{th}$ piece of incremental data in the P pieces of incremental data is subdata of the third data, and the $q^{th}$ piece of incremental data comprises location indication information and weighting coefficients of $h_q$ basis vectors in the third data; or
a $q^{th}$ piece of incremental data in the P pieces of incremental data is subdata of fourth data; the $q^{th}$ piece of incremental data comprises weighting coefficients of the k basis vectors in the fourth data and/or a weighting coefficient of a basis vector in at least one of first q-1 pieces of incremental data in the P pieces of incremental data, and location indication information and weighting coefficients of $h_q$ basis vectors in the fourth data; and the fourth data is determined based on the dictionary matrix, the first data, and fourth data corresponding to a $(q-1)^{th}$ piece of incremental data, and when q is equal to 1, the fourth data corresponding to the $(q-1)^{th}$ piece of incremental data is the second data, wherein

$h_q$ is an integer less than K and greater than or equal to 1, and a sum of a quantity $\sum_{q=1}^{P} h_q$ of basis vectors in the P pieces of incremental data and k is less than or equal to K.

10. The method according to claim 9, wherein the $h_q$ basis vectors are first $h_q$ basis vectors that are other than the k basis

$$\sum_{r=1}^{q-1} h_r$$

vectors in the K basis vectors and $\sum_{r=1}^{q-1} h_r$ basis vectors in the first q-1 pieces of incremental data and that are in descending order of capabilities of expressing the first data, wherein $h_r$ is a quantity of basis vectors in one of the first q-1 pieces of incremental data.

11. The method according to any one of claims 1 to 10, wherein the second data comprises location indication information and/or the weighting coefficients of the k basis vectors.

12. The method according to any one of claims 1 to 11, wherein the method further comprises:

> performing, by the first communication apparatus, quantization and/or entropy encoding on the second data to obtain compressed data of the second data; and
> the sending, by the first communication apparatus, the second data to a second communication apparatus on the first transmission resource comprises:
> sending, by the first communication apparatus, the compressed data of the second data to the second communication apparatus on the first transmission resource.

13. The method according to any one of claims 1 to 12, wherein the method further comprises:
sending, by the first communication apparatus, the dictionary matrix to the second communication apparatus.

14. The method according to any one of claims 2 to 6, wherein a data feature of the first dataset or the second dataset comprises at least one of a data amount, data boundary values, and a mean variance.

15. The method according to any one of claims 2 to 6, wherein the method further comprises:
clustering, by the first communication apparatus, the M first datasets based on one of the following, to obtain the N second datasets:

> data types of the M first datasets; and
> boundary values of elements in the M first datasets.

16. The method according to any one of claims 2 to 6, wherein the method further comprises:
sending, by the first communication apparatus, category indication information to the second communication apparatus, wherein the category indication information indicates a clustering category of each of the M first datasets.

17. The method according to any one of claims 1 to 16, wherein the first communication apparatus receives indication information that is sent by the second communication apparatus and that is of a second transmission resource, and the second transmission resource is used to transmit incremental data of the second data.

18. The method according to claim 17, wherein the method further comprises:
sending, by the first communication apparatus, a transmission request to the second communication apparatus, wherein the transmission request is used to request to send the incremental data of the second data.

19. The method according to any one of claims 1 to 18, wherein the method further comprises:
receiving, by the first communication apparatus, compression indication information sent by the second communication apparatus, wherein the compression indication information comprises compression hyperparameter information, the compression hyperparameter information indicates at least a target weighting parameter, the target weighting parameter is used to determine k, and the target weighting parameter is greater than or equal to k.

20. The method according to any one of claims 1 to 19, wherein the method further comprises:
sending, by the first communication apparatus, the compression indication information to the second communication apparatus, wherein the compression indication information comprises the compression hyperparameter information, the compression hyperparameter information indicates at least the target weighting parameter, the target weighting parameter is used to determine k, and the target weighting parameter is greater than or equal to k.

21. The method according to claim 19 or 20, wherein the compression hyperparameter information comprises at least one of the following:

configuration information of the first transmission resource, wherein the first transmission resource indicates the target weighting parameter; and

information indicating a dimension of a basis vector and/or a quantity of basis vectors in the dictionary matrix.

22. The method according to any one of claims 19 to 21, wherein the compression indication information further comprises at least one of the following:

information indicating a clustering manner of the M first datasets in the first data;

information indicating a compression manner of one or more of the N second datasets in the first data; and

information indicating whether to perform entropy encoding on the second data.

23. The method according to claim 22, wherein
the first communication apparatus determines the compression manner of the one or more of the N second datasets based on a data feature of the first data.

24. The method according to any one of claims 1 to 23, wherein the method further comprises:
sending, by the first communication apparatus, compression parameter information to the second communication apparatus, wherein the compression parameter information comprises at least one of the following:

boundary values of the dictionary matrix; and

boundary values of the weighting coefficients of the basis vectors in the second data.

25. The method according to any one of claims 1 to 24, wherein the method further comprises:
sending, by the first communication apparatus, feedback information to the second communication apparatus, wherein the feedback information comprises a weighting parameter $k_m$, and the weighting parameter $k_m$ is used to adjust a size of a transmission resource in a next round.

26. A data compression and transmission method, comprising:

receiving, by a second communication apparatus on a first transmission resource, second data from a first communication apparatus, wherein the second data expresses first data based on k basis vectors in a dictionary matrix, k is a weighting parameter that is determined based on the first transmission resource and that is of the first data, and k is an integer greater than or equal to 1; and

constructing, by the second communication apparatus, the first data based on the second data and the dictionary matrix.

27. The method according to claim 26, wherein the first data comprises M first datasets, the M first datasets are clustered into N second datasets, the second dataset comprises at least one first dataset, and M and N are both integers greater than or equal to 1.

28. The method according to claim 27, wherein the weighting parameter k of the first data comprises a first weighting parameter k' corresponding to each second dataset in the N second datasets; and
the second data comprises an $i^{th}$ first sub-dataset obtained by performing weighted encoding on an $i^{th}$ second dataset based on the first weighting parameter $k_i'$, and the $i^{th}$ first sub-dataset expresses the $i^{th}$ second dataset based on $k_i'$ basis vectors in the dictionary matrix.

29. The method according to claim 28, wherein the dictionary matrix comprises N dictionary submatrices respectively corresponding to the N second datasets, and the N dictionary submatrices comprise at least two different dictionary submatrices.

30. The method according to claim 28 or 29, wherein the first weighting parameter $k_i'$ corresponding to the $i^{th}$ second dataset comprises a second weighting parameter $k_i''$ corresponding to each first dataset in the $i^{th}$ second dataset; and

the $i^{th}$ first sub-dataset comprises a $j^{th}$ piece of subdata obtained by performing weighted encoding on a $j^{th}$ first dataset in the $i^{th}$ second dataset based on the second weighting parameter $k_{ij}''$, and the $j^{th}$ piece of subdata in the $i^{th}$ first sub-dataset expresses the $j^{th}$ first dataset in the $i^{th}$ second dataset based on $k_{ij}''$ basis vectors in an $i^{th}$ dictionary submatrix corresponding to the $i^{th}$ second dataset, wherein
the second weighting parameter $k_{ij}''$ is determined based on a data feature of the $j^{th}$ first dataset in the $i^{th}$ second dataset.

31. The method according to any one of claims 28 to 30, wherein K basis vectors in third data comprise $K_i'$ basis vectors corresponding to the $i^{th}$ second dataset, the third data is obtained by performing weighted encoding on each second dataset in the first data, the K basis vectors comprise the k basis vectors, and the $k_i'$ basis vectors in the $i^{th}$ second dataset are first $k_i'$ basis vectors that are in the $K_i'$ basis vectors and that are in descending order of capabilities of expressing the first data.

32. The method according to claim 26, wherein third data expresses the first data based on K basis vectors in the dictionary matrix, and the third data is obtained by performing weighted encoding on the first data.

33. The method according to claim 32, wherein the k basis vectors are first k basis vectors that are in the K basis vectors in the dictionary matrix and that are in descending order of capabilities of expressing the first data.

34. The method according to claim 32 or 33, wherein the method further comprises:

receiving, by the second communication apparatus, P pieces of incremental data that are sent by the first communication apparatus and that are of the second data, wherein P is an integer greater than or equal to 1; and a $q^{th}$ piece of incremental data in the P pieces of incremental data is subdata of the third data, and the $q^{th}$ piece of incremental data comprises location indication information and weighting coefficients of $h_q$ basis vectors in the third data; or
a $q^{th}$ piece of incremental data in the P pieces of incremental data is subdata of fourth data; the $q^{th}$ piece of incremental data comprises weighting coefficients of the k basis vectors in the fourth data and/or a weighting coefficient of a basis vector in at least one of first q-1 pieces of incremental data in the P pieces of incremental data, and location indication information and weighting coefficients of $h_q$ basis vectors in the fourth data; and the fourth data is determined based on the dictionary matrix, the first data, and fourth data corresponding to a $(q-1)^{th}$ piece of incremental data, and when q is equal to 1, the fourth data corresponding to the $(q-1)^{th}$ piece of incremental data is the second data, wherein

$h_q$ is an integer less than K and greater than or equal to 1, and a sum of a quantity $\sum_{q=1}^{P} h_q$ of basis vectors in the P pieces of incremental data and k is less than or equal to K.

35. The method according to claim 34, wherein the $h_q$ basis vectors are first $h_q$ basis vectors that are other than the k basis vectors in the K basis vectors and $\sum_{r=1}^{q-1} h_r$ basis vectors in the first q-1 pieces of incremental data and that are in descending order of capabilities of expressing the first data, wherein $h_r$ is a quantity of basis vectors in one of the first q-1 pieces of incremental data.

36. The method according to any one of claims 26 to 35, wherein the second data comprises location indication information and/or the weighting coefficients of the k basis vectors.

37. The method according to any one of claims 26 to 36, wherein

the receiving, by a second communication apparatus on a first transmission resource, second data from a first communication apparatus comprises: receiving, by the second communication apparatus on the first transmission resource, compressed data that is sent by the first communication apparatus and that is of the second data, wherein the compressed data of the second data is obtained by performing quantization and/or entropy encoding on the second data; and
decompressing, by the second communication apparatus, the compressed data of the second data to obtain the second data.

38. The method according to any one of claims 26 to 37, wherein the method further comprises:

receiving, by the second communication apparatus, the dictionary matrix sent by the first communication apparatus.

39. The method according to any one of claims 27 to 31, wherein a data feature of the first dataset or the second dataset comprises at least one of a data amount, data boundary values, and a mean variance.

40. The method according to any one of claims 27 to 31, wherein the method further comprises:
receiving, by the second communication apparatus, category indication information sent by the first communication apparatus, wherein the category indication information indicates a clustering category of each of the M first datasets.

41. The method according to claim 34 or 35, wherein the second communication apparatus receives indication information that is sent by the first communication apparatus and that is of a second transmission resource, and the second transmission resource is used to transmit incremental data of the second data.

42. The method according to claim 41, wherein the method further comprises:
receiving, by the second communication apparatus, a transmission request sent by the first communication apparatus, wherein the transmission request is used to request to send the incremental data of the second data.

43. The method according to any one of claims 26 to 42, wherein the method further comprises:
sending, by the second communication apparatus, the compression indication information to the first communication apparatus, wherein the compression indication information comprises compression hyperparameter information, the compression hyperparameter information indicates at least a target weighting parameter, the target weighting parameter is used to determine k, and the target weighting parameter is greater than or equal to k.

44. The method according to any one of claims 26 to 43, wherein the method further comprises:
receiving, by the second communication apparatus, the compression indication information sent by the first communication apparatus, wherein the compression indication information comprises the compression hyperparameter information, the compression hyperparameter information indicates at least the target weighting parameter, the target weighting parameter is used to determine k, and the target weighting parameter is greater than or equal to k.

45. The method according to claim 43 or 44, wherein the compression hyperparameter information comprises at least one of the following:

configuration information of the first transmission resource, wherein the first transmission resource indicates the target weighting parameter; and
information indicating a dimension of a basis vector and/or a quantity of basis vectors in the dictionary matrix.

46. The method according to any one of claims 43 to 45, wherein the compression indication information further comprises at least one of the following:

information indicating a clustering manner of the M first datasets in the first data;
information indicating a compression manner of one or more of the N second datasets in the first data; and
information indicating whether to perform entropy encoding on the second data.

47. The method according to any one of claims 26 to 46, wherein the method further comprises: receiving, by the second communication apparatus, compression parameter information sent by the first communication apparatus, wherein the compression parameter information comprises at least one of the following:

boundary values of the dictionary matrix; and
boundary values of the weighting coefficients of the basis vectors in the second data.

48. The method according to any one of claims 26 to 47, wherein the method further comprises:
receiving, by the second communication apparatus, feedback information sent by the first communication apparatus, wherein the feedback information comprises a weighting parameter $k_m$, and the weighting parameter $k_m$ is used to adjust a size of a transmission resource in a next round.

49. A communication apparatus, comprising a module configured to perform the method according to any one of claims 1 to 25 or comprising a module configured to perform the method according to any one of claims 26 to 48.

50. A communication apparatus, comprising a processor, wherein the processor is configured to perform the method according to any one of claims 1 to 48 by running a computer program or by using a logic circuit.

**51.** The apparatus according to claim 50, further comprising a memory, wherein the memory is configured to store the computer program.

**52.** The apparatus according to claim 50 or 51, further comprising a communication interface, wherein the communication interface is configured to input and/or output a signal.

**53.** A communication system, comprising a first communication apparatus configured to perform the method according to any one of claims 1 to 25, and a second communication apparatus configured to perform the method according to any one of claims 26 to 48.

**54.** A computer-readable storage medium, configured to store computer program instructions, wherein the computer program enables a computer to perform the method according to any one of claims 1 to 48.

**55.** A computer program product, comprising computer program instructions, wherein the computer program instructions enable a computer to perform the method according to any one of claims 1 to 48.

<u>100</u>

FIG. 1

FIG. 2

y            D            x

L

d

d₂      d₅      d₈

FIG. 3

200

First communication apparatus

Second communication apparatus

S210: The first communication apparatus performs weighted encoding on first data based on a dictionary matrix, to obtain second data, where the second data expresses the first data based on k basis vectors in the dictionary matrix, k is a weighting parameter that is determined based on a first transmission resource and that is of the first data, and k is an integer greater than or equal to 1

S220: Send the second data on the first transmission resource

S230: Construct the first data based on the second data and the dictionary matrix

FIG. 4

First communication apparatus 310

First data

Data clustering

Weighted encoding

...

Weighted encoding

Second communication apparatus 320

Weighted decoding

Weighted decoding

Data restoration

Restored data

FIG. 5

First data

Clustering

$1^{st}$ second data matrix set

...

$N^{th}$ second data matrix set

Weighted encoding

$1^{st}$ piece of first subdata

$1^{st}$ dictionary submatrix

Weighted encoding

$N^{th}$ piece of first subdata

$N^{th}$ dictionary submatrix

Second data

FIG. 6

First data matrix A
$e–02 \leq |a| \leq e–01$

First data matrix B
$|b| \leq e–02$

First data matrix M–1
$e–02 \leq |c| \leq e–01$

First data matrix M
$|d| \leq e–02$

Clustering category 1

Clustering category 2

FIG. 7

FIG. 8

First data

Column vector $y_1$

First layer | Second layer | $(P+1)^{th}$ layer

$(i_{(1, 1)}, i_{(2, 1)},$ | $i_{(3, 1)}, i_{(4, 1)},$ | ... | $i_{(k-1, 1)}, i_{(k, 1)})$

$(c_{(1, 1)}, i_{(2, 1)},$ | $i_{(3, 1)}, i_{(4, 1)},$ | ... | $i_{(k-1, 1)}, i_{(k, 1)})$

...

Column vector $y_w$

$(i_{(1, w)}, i_{(2, w)},$ | $i_{(3, w)}, i_{(4, w)},$ | ... | $i_{(k-1, w)}, i_{(k, w)})$

$(c_{(1, w)}, c_{(2, w)},$ | $c_{(3, w)}, c_{(4, w)},$ | ... | $c_{(k-1, w)}, c_{(k, w)})$

FIG. 9

400a

First communication apparatus

Second communication apparatus

S410a: Send compression indication information

S420a: Send configuration information of a first transmission resource

S430a: Perform weighted encoding based on the first transmission resource, to obtain second data

S440a: Send the second data on the first transmission resource

S450a: Construct first data based on the second data

FIG. 10a

400b

```
┌─────────────────┐                              ┌─────────────────┐
│      First       │                              │     Second       │
│  communication   │                              │  communication   │
│    apparatus     │                              │    apparatus     │
└─────────────────┘                              └─────────────────┘
         │      S410b: Send configuration information of a      │
         │◄──────────────────────────────────────────────────  │
         │            first transmission resource               │
         │                                                      │
         │  — S420b: Send compression indication information ─► │
         │                                                      │
┌──────────────────────────────────────────┐                  │
│ S430b: Perform weighted encoding based on the first │        │
│  transmission resource, to obtain second data       │        │
└──────────────────────────────────────────┘                  │
         │          S440b: Send the second data on the first    │
         │──────────────────────────────────────────────────► │
         │               transmission resource                  │
         │                                                      │
         │    ┌──────────────────────────────────────────────┐ │
         │    │ S450b: Construct first data based on the second data │
         │    └──────────────────────────────────────────────┘ │
         │                                                      │
```

FIG. 10b

400c

| First communication apparatus | | Second communication apparatus |
|---|---|---|

**← S410c: Send first compression indication information —**

S420c: Send configuration information of a first transmission resource

**⊢ S430c: Send second compression indication information →**

S440c: Perform weighted encoding based on the first transmission resource, to obtain second data

S450c: Send the second data on the first transmission resource

S460c: Construct first data based on the second data

FIG. 10c

400d

First communication apparatus | Second communication apparatus

← S410d: Send compression indication information

← S420d: Send configuration information of a first transmission resource

S430d: Perform weighted encoding based on the first transmission resource, to obtain second data

S440d: Send the second data on the first transmission resource →

**S450d: Send incremental transmission signaling →**

**S460d: Determine to perform incremental transmission, and send configuration information of a second transmission resource ←**

**S470d: Send incremental data of the second data →**

S480d: Construct first data based on the second data and the incremental data of the second data

FIG. 10d

Communication apparatus 500

Transceiver module 510

Processing module 520

FIG. 11

Communication apparatus 600

Processor
610

Memory
630

Transceiver
620

FIG. 12

## INTERNATIONAL SEARCH REPORT

| International application No. |
|---|
| **PCT/CN2022/123576** |

| **A.** | **CLASSIFICATION OF SUBJECT MATTER** |
|---|---|
| | H04L 27/00(2006.01)i |

According to International Patent Classification (IPC) or to both national classification and IPC

| **B.** | **FIELDS SEARCHED** |
|---|---|

Minimum documentation searched (classification system followed by classification symbols)

　　IPC: H04L, H04B, G06T,G06N

Documentation searched other than minimum documentation to the extent that such documents are included in the fields searched

Electronic data base consulted during the international search (name of data base and, where practicable, search terms used)

　　VEN, CNABS, CNTXT, WOTXT, EPTXT, USTXT, CNKI, IEEE: 编码, 传输资源, 基向量, 加权, 加权编码, 加权参数, 加权系数, 稀疏度, 压缩, 传输, 原子, 字典矩阵, 字典学习, coding, weighting, coefficient, sparse, compression, transmission, matrix, dictionary, learning

| **C.** | **DOCUMENTS CONSIDERED TO BE RELEVANT** |
|---|---|

| Category* | Citation of document, with indication, where appropriate, of the relevant passages | Relevant to claim No. |
|---|---|---|
| A | CN 115053465 A (HUAWEI TECHNOLOGIES CO., LTD.) 13 September 2022 (2022-09-13) description, paragraphs [0300]-[0575] | 1-55 |
| A | CN 114614955 A (HUAWEI TECHNOLOGIES CO., LTD.) 10 June 2022 (2022-06-10) entire document | 1-55 |
| A | CN 112184840 A (SHANGHAI JIAO TONG UNIVERSITY) 05 January 2021 (2021-01-05) entire document | 1-55 |
| A | US 2019095787 A1 (KONG XIANGZHONG et al.) 28 March 2019 (2019-03-28) entire document | 1-55 |

☐ Further documents are listed in the continuation of Box C.　　☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **20 March 2023** | **23 March 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**INTERNATIONAL SEARCH REPORT**
Information on patent family members

International application No.

**PCT/CN2022/123576**

| Patent document cited in search report | | | Publication date (day/month/year) | Patent family member(s) | | | Publication date (day/month/year) |
|---|---|---|---|---|---|---|---|
| CN | 115053465 | A | 13 September 2022 | WO | 2021155610 | A1 | 12 August 2021 |
| | | | | EP | 4092919 | A1 | 23 November 2022 |
| | | | | US | 2022385343 | A1 | 01 December 2022 |
| CN | 114614955 | A | 10 June 2022 | WO | 2022121797 | A1 | 16 June 2022 |
| CN | 112184840 | A | 05 January 2021 | WO | 2022063055 | A1 | 31 March 2022 |
| US | 2019095787 | A1 | 28 March 2019 | WO | 2019067265 | A1 | 04 April 2019 |

Form PCT/ISA/210 (patent family annex) (July 2022)